# EUROPEAN PATENT APPLICATION

(11) **EP 3 178 632 A1**
(43) Date of publication of application: **14.06.2017**
(21) Application number: 15830719.9
(22) Date of filing: 03.08.2015
(51) Int. Cl.: B29C 59/02, B29C 65/52, H01L 21/027, H01L 51/50, H05B 33/02

(54) **METHOD FOR MANUFACTURING MEMBER HAVING IRREGULAR PATTERN**

(30) Priority: 04.08.2014 JP 2014158406; 10.09.2014 JP 2014184202
(71) Applicant: JX Nippon Oil & Energy Corporation, Chiyoda-ku Tokyo 100-8162 (JP)
(72) Inventor: TAKAHASHI, Madoka, Tokyo 100-8162 (JP); TORIYAMA, Shigetaka, Tokyo 100-8162 (JP); SEKI, Takashi, Tokyo 100-8162 (JP); SATO, Yusuke, Tokyo 100-8162 (JP)
(74) Representative: Kuhnen & Wacker
(86) International application number: PCT/JP2015/071923
(87) International publication number: WO 2016/021533

(57) **Abstract**

A method for manufacturing a member with a concave-convex pattern includes: a step of forming a first film 60 on a concave-convex pattern formed on a surface of a mold 140; a step of forming a second film 70 on a base member 40; a step of joining the first film 60 and the second film 70 by overlapping the mold 140 with the base member 40; and a step of releasing the mold 140 from the first film 60 joined to the second film 70. A method for manufacturing a functional member with a concave-convex pattern is provided.

## Description

### TECHNICAL FIELD

The present invention relates to a method for manufacturing a member having an irregular pattern (concave-convex pattern, concave and convex pattern).

### BACKGROUND ART

As a method for forming a fine convex-concave pattern (minute convex-concave pattern), such as a semiconductor integrated circuit, nanoimprint methods as well as lithography methods are known. The nanoimprint method is technology capable of transferring a pattern in nanometer order from a mold (die) to a substrate by sandwiching a resin between the mold and the substrate. A thermal nanoimprint method, a photonanoimprint method, or the like is used depending on an employed material. Of the above methods, the photonanoimprint method includes four steps of: i) forming a curable resin coating layer; ii) pressing with the mold against the curable resin layer; iii) photocuring of the curable resin layer; and iv) mold-releasing from the curable resin layer. The photonanoimprint method is excellent in that processing on a nanoscale can be achieved by such a simple process. Especially, since a photo-curable resin curable by being irradiated with light is used, a period of time for a pattern transfer step is short and high throughput is promised. Thus, the photonanoimprint method is expected to be practiced not only in the field of semiconductor devices but also in many fields, such as optical members like organic EL (electro-luminescence) element, LED, etc.; MEMS; biochips; and the like.

For example, in the organic EL element (organic light emitting diode), a hole injected from an anode through a hole injecting layer and electron injected from a cathode through an electron injecting layer are carried to a light emitting layer respectively, then the hole and electron are recombined on an organic molecule in the light emitting layer to excite the organic molecule, thereby generating light emission. Therefore, when the organic EL element is used as a display device and/or an illumination device, the light from the light emitting layer is required to be efficiently extracted from the surface of the organic EL element. In order to meet this demand, PATENT LITERATURE 1 discloses that a substrate having a fine concave-convex pattern that serves as a diffraction grating is provided on a light extraction surface of the organic EL element.

As a base member of the organic EL element, a film base member such as a film base member which is formed of a resin, which is light and flexible, and can be produced in a large size, has started to be adopted, in place of a glass substrate that is heavy, easily broken, and hard to be produced in a large size. Unfortunately, the film base member such as resin has a gas barrier property inferior to that of the glass substrate. In the organic EL element, any moisture and/or oxygen might reduce luminance, light emitting efficiency, and the like. Thus, when a resin-film base member is used as the base member of the organic EL element, a gas barrier layer is required to be formed on the resin-film base member to prevent any deterioration caused by moisture and/or gas including oxygen. For example, PATENT LITERATURES 2 and 3 describe that a gas barrier layer formed by an inorganic film is formed through a sputtering method, a vacuum evaporation method, an ion plating method, a plasma CVD method, or the like.

### [Citation List]

### [Patent Literature]

PATENT LITERATURE 1: Japanese Patent Application Laid-open No. 2006-236748
PATENT LITERATURE 2: Japanese Patent Application Laid-open No. 2011-102042
PATENT LITERATURE 3: Japanese Patent Application Laid-open No. 2013-253319

### SUMMARY OF INVENTION

### Problem to be Solved by the Invention:

As described above, it is required to extract light from the organic EL element at high efficiency by providing the substrate with the concave-convex pattern in the organic EL element. Further, it is required to achieve a long service life of the organic EL element by providing a layer with a good gas barrier property in the organic EL element. In order to meet these demands, forming a concave-convex pattern in a surface of the gas barrier layer is favorable in view of production efficiency. Unfortunately, an inorganic film formed by a dry process, such as sputtering, is hard, and thus there is a problem that the concave-convex pattern can not be formed on a surface of the inorganic film through conventional nanoimprint methods.

An object of the present invention is to provide a method for manufacturing a functional member with a functional layer, such as a gas barrier layer having a surface in which a concave-convex pattern is formed. Another object of the present invention is to provide a method for manufacturing a member with a film that is formed by a dry process and has a surface in which a concave-convex pattern is formed.

### Solution to the Problem:

According to the first aspect of the present invention, there is provided a method for manufacturing a member with a concave-convex pattern, including: a step of forming a first film on a concave-convex pattern formed on a surface of a mold; a step of forming a second film on a base member; a step of joining the first film and the second film by overlapping the mold with the base member (overlaying the mold on the base member); and a step of releasing the mold from the first film joined to the second film.

The method for manufacturing the member with the concave-convex pattern may further include a step of applying adhesive on the first film formed on the mold or the second film formed on the base member before the joining step.

The method for manufacturing the member with the concave-convex pattern may further include a step of forming, on the first film formed on the mold, a film different from the first film and/or a step of forming, on the second film formed on the base member, a film different from the second film, before the joining step.

According to the second aspect of the present invention, there is provided a method for manufacturing a member with a concave-convex pattern, including: a step of forming a first film, through a dry process, on a concave-convex pattern formed on a surface of a mold; a step of joining a base member to the first film formed on the mold; and a step of releasing the mold from the first film.

The method for manufacturing the member with the concave-convex pattern may further include a step of applying adhesive on a surface, of the base member, which is to be joined to the first film formed on the mold, or on the first film formed on the mold before the joining step.

The method for manufacturing the member with the concave-convex pattern may further include a step of forming a film different from the first film, through the dry process and/or a wet process, on the first film formed on the concave-convex pattern of the mold.

In the first film formation step of the method for manufacturing the member with the concave-convex pattern, the first film may be formed by depositing silicon oxide, silicon oxynitride, or silicon nitride through the dry process.

The method for manufacturing the member with the concave-convex pattern may include a step of forming a second film on the base member before the joining step.

In the method for manufacturing the member with the concave-convex pattern, the first film and/or the second film may have a water vapor transmission rate of not more than 10⁻² g·m⁻²·day⁻¹.

In the method for manufacturing the member with the concave-convex pattern, a first gas barrier layer formed by the first film and the film which is formed on the first film and different from the first film and/or a second gas barrier layer formed by the second film and the film which is formed on the second film and different from the second film may have a water vapor transmission rate of not more than 10⁻² g·m⁻²·day⁻¹.

In the method for manufacturing the member with the concave-convex pattern, (i) each of a plurality of convexities and each of a plurality of concavities of the concave-convex pattern of the mold may have an elongated shape which extends while winding in a plane view; and (ii) the plurality of convexities may have extending directions, bending directions and lengths which are non-uniform among the plurality of convexities, and the plurality of concavities may have extending directions, bending directions and lengths which are non-uniform among the plurality of concavities.

In the method for manufacturing the member with the concave-convex pattern, the concave-convex pattern of the mold may be an irregular concave-convex pattern in which an average pitch of concavities and convexities is in a range of 100 to 1500 nm and an average value of depth distribution of the concavities and convexities is in a range of 20 to 200 nm.

In the method for manufacturing the member with the concave-convex pattern, a Fourier-transformed image of a concavity and convexity analysis image of the mold may show a circular or annular pattern substantially centered at an origin at which an absolute value of wavenumber is 0 µm⁻¹, and the circular or annular pattern may be present within a region where the absolute value of wavenumber is in a range of not more than 10 µm⁻¹.

According to the third aspect of the present invention, there is provided a member with a concave-convex pattern manufactured by the method for manufacturing the member with the concave-convex pattern as defined in the first aspect or the second aspect.

The member with the concave-convex pattern may include a gas barrier layer, and the first film may be included in the gas barrier layer.

In the member with the concave-convex pattern, the gas barrier layer may have a water vapor transmission rate of not more than 10⁻² g·m⁻²·day⁻¹.

According to the fourth aspect of the present invention, there is provided an organic light emitting diode formed by successively stacking, on the member with the concave-convex pattern as defined in the third aspect, a first electrode, an organic layer, and a metal electrode.

### EFFECT OF INVENTION

In the method for manufacturing the member with the concave-convex pattern (concave-convex structure) according to the first aspect of the present invention, the first film (first functional layer) is formed on the concave-convex pattern of the mold, the second film (second functional layer) is formed on the base member, and the first film and the second film are joined by overlapping the mold with the base member. Thus, there is little restriction on the materials and coating methods for the first film and the second film and it is possible to manufacture a functional member having a good function. In the method for manufacturing the member with the concave-convex pattern according to the second aspect of the present invention, the concave-convex pattern is formed directly on the surface of the first film formed by the dry process, resulting in high production efficiency. Each of the methods according to the first and second aspects forms the member with the concave-convex pattern by transfer of the concave-convex pattern of the mold, without using photolithography that causes a large amount of waste liquid, thus resulting in being environmentally friendly. The manufacturing method according to the present invention can manufacture the gas barrier member with the concave-convex pattern by forming the film(s) having the gas barrier property, as the first film and/or the second film. In particular, when the first film is formed by the dry process, the gas barrier layer including the first film has a very good gas barrier property. The gas barrier member having such a gas barrier layer has the concave-convex pattern, thus providing high light extraction efficiency. Therefore, a light emitting element manufactured by using this member has a sufficient light-emitting efficiency and a long service life due to the suppression of the deterioration caused by moisture and/or gas such as oxygen. Accordingly, the method for manufacturing the member with the concave-convex pattern according to the present invention is effective in manufacture of the gas barrier member used for various devices, such as organic EL elements and solar cells. Further, the gas barrier member manufactured by the manufacturing method according to the present invention is suitably used for packaging applications, such as packaging of goods and packaging for preventing any deterioration of foods, industrial goods, medical products, and the like.

### BRIEF DESCRIPTION OF DRAWINGS

Fig. 1(a) is a schematic cross-sectional view of a member obtained by a method for manufacturing a member with a concave-convex pattern according to a first embodiment, and Fig. 1(b) is a schematic cross-sectional view of a member obtained by a method for manufacturing a member with a concave-convex pattern according to a first modified embodiment.
Fig. 2(a) is a schematic plan view of the concave-convex pattern of the member obtained by the manufacturing method of the first embodiment, and Fig. 2(b) is a cross-section profile taken along the cutting-plane line in Fig. 2(a).
Fig. 3 depicts an exemplary Fourier-transformed image of a concavity and convexity analysis image of a surface of a first film.
Fig. 4 is a flowchart indicating the method for manufacturing the member with the concave-convex pattern according to the first embodiment.
Figs. 5(a) to 5(d) conceptually depict steps of the method for manufacturing the member with the concave-convex pattern according to the first embodiment.
Fig. 6(a) conceptually depicts an exemplary first film formation step, joining step, and releasing step in the manufacturing method of the first embodiment, and Fig. 6(b) conceptually depicts an exemplary adhesive applying step, joining step, and releasing step in the manufacturing method of the first modified embodiment.
Fig. 7 conceptually depicts a sputtering apparatus that can be used to form the first film or a second film on a film-shaped mold or film-shaped base member.
Fig. 8(a) is a schematic cross-sectional view of a member obtained by a method for manufacturing a member with a concave-convex pattern according to a second embodiment, and Fig. 8(b) is a schematic cross-sectional view of a member obtained by a method for manufacturing a member with a concave-convex pattern according to a fourth modified embodiment.
Fig. 9 is a flowchart indicating the method for manufacturing the member with the concave-convex pattern according to the second embodiment.
Figs. 10(a) to 10(d) conceptually depict steps of the method for manufacturing the member with the concave-convex pattern according to the second embodiment.
Fig. 11(a) conceptually depicts an exemplary adhesive applying step, joining step, and releasing step in the manufacturing method of the second embodiment, and Fig. 11(b) conceptually depicts an exemplary adhesive applying step, joining step, and releasing step in the manufacturing method of the fourth modified embodiment.
Fig. 12(a) conceptually depicts a cross-sectional structure of a light emitting element that is formed by using a gas barrier member manufactured through the method of the first embodiment, and Fig. 12(b) conceptually depicts a cross-sectional structure of a light emitting element that is formed by using a gas barrier member manufactured through the method of the first modified embodiment.
Fig. 13(a) conceptually depicts a cross-sectional structure of a light emitting element that is formed by using a gas barrier member manufactured through the method of the second embodiment, and Fig. 13(b) conceptually depicts a cross-sectional structure of a light emitting element that is formed by using a gas barrier member manufactured through the method of the fourth modified embodiment.

### DESCRIPTION OF EMBODIMENTS

In the following, embodiments of a member with a concave-convex structure (concave-convex pattern), a method for manufacturing the member with the concave-convex structure, and a light emitting element manufactured by using the member with the concave-convex structure according to the present invention will be explained with reference to the drawings. The following describes, in the first embodiment of the present invention, a case in which a gas barrier member is manufactured by forming films having a gas barrier property as a first film (first functional layer) and a second film (second functional layer) and describes, in the second embodiment of the present invention, a case in which a gas barrier member is manufactured by forming a film having a gas barrier property as the first film (first functional layer). As described later, the first film and/or the second film is/are not limited to the film having the gas barrier property. The first film and/or the second film may be a film having various functions so as to manufacture a member with various functions. The manufactured member is applicable not only to the light emitting element but also to a variety of uses.

### [First gas barrier member]

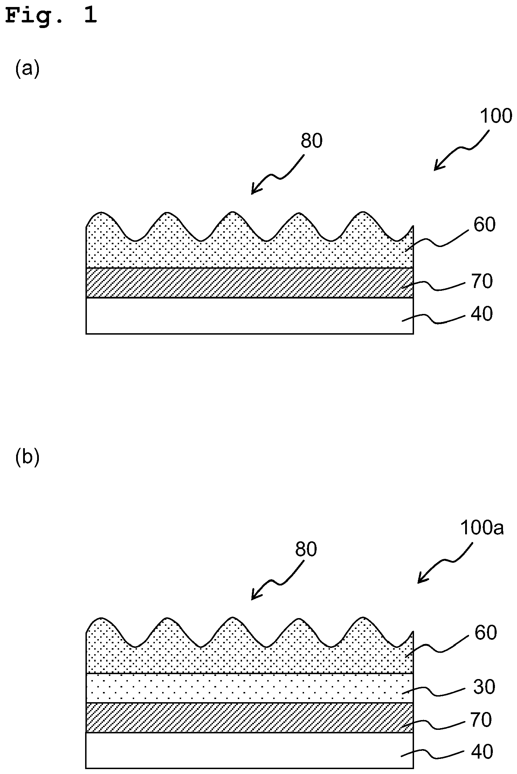

As depicted in Fig. 1(a), in a gas barrier member 100 with a concave-convex structure (concave-convex pattern) 80 obtained in the first embodiment of the method for manufacturing the gas barrier member with the concave-convex pattern as described later, a second film 70 (second gas barrier layer) and a first film 60 (first gas barrier layer) are formed on a base member 40 in that order. As depicted in Fig. 1(b), in a gas barrier member 100a obtained in the first modified embodiment of the method for manufacturing the gas barrier member with the concave-convex pattern as described later, the second film 70 is formed on the base member 40 and the first film 60 is formed on the second film 70 via an adhesive layer 30.

### <Base member>

The base member 40 is not especially limited, it is possible to appropriately use any publicly known transparent substrate which can be used for the light emitting element. The base member 40 may be a hard substrate or a flexible film-shaped substrate. For example, it is possible to use substrates made from transparent inorganic materials, such as glass, and substrates made from resins. Examples of substrates made from resins include polyester (polyethylene terephthalate, polybutylene terephthalate, polyethylene naphthalate, polyarylate, and the like), an acrylic-based resin (polymethyl methacrylate and the like), polycarbonate, polyvinyl chloride, a styrene-based resin (ABS resin and the like), a cellulose-based resin (triacetyl cellulose and the like), a polyimide-based resin (polyimide resin, polyimideamide resin, and the like) and cycloolefin polymer. When the gas barrier member 100 is used as an optical substrate of the light emitting element, the base member 40 desirably has heat resistance and weather resistance to UV light and the like. In view of those points, base members made from inorganic materials, such as glass and quarts substrates, are more preferably used. In particular, when the first film 60 is made from the inorganic material, the base member 40 is preferably made from the inorganic material. This is because the difference between a refractive index of the base member 40 and a refractive index of the first film 60 is small, which in turn makes it possible to prevent any unintended refraction and/or reflection in the light emitting element when the gas barrier member 100 is used as the optical substrate of the light emitting element. It is allowable to perform a surface treatment for the base member 40 or to provide an easy-adhesion layer on the base member 40 so as to improve the adhesion property of the base member 40 and/or it is allowable to provide a smoothing layer to cover any protrusion on a surface of the base member 40. The thickness of the base member 40 is preferably in a range of 1 µm to 20 mm.

### <First film>

The gas barrier member 100 includes the first film 60 that is formed as the first gas barrier layer preventing permeation of oxygen and water vapor. The first film 60 may be made from an inorganic material or an organic material (resin material). As the inorganic material, inorganic oxide, inorganic nitride, inorganic oxynitride, inorganic sulfide, inorganic carbide, or the like is preferably used; silicon oxide, aluminum oxide, magnesium oxide, zinc oxide, indium oxide, tin oxide, titanic oxide, copper oxide, cerium oxide, tantalum oxide, zirconium oxide, indium tin oxide, barium titanate, strontium titanate, silicon nitride, silicon oxynitride, aluminum oxynitride, zinc sulfide, or the like is more preferably used. Examples of the organic material include materials that may be used as a sealing material of an organic EL element, such as XNR5516Z produced by NAGASE & CO., LTD., TB3124 produced by THREEBOND HOLDINGS CO., LTD., and CELVENUS H001 produced by Daicel Corporation.

The first film 60 may be a film in which an ultraviolet absorbent material is included in the inorganic material or the organic material. The ultraviolet absorbent material has a function or effect to prevent deterioration of the film by absorbing ultraviolet rays and converting light energy into something harmless such as heat. Any publicly known agent may be used as the ultraviolet absorbent material. Those usable as the ultraviolet absorbent material include, for example, benzotriazole-based absorbents, triazine-based absorbents, salicylic acid derivative-based absorbents, benzophenone-based absorbents, etc.

The first film 60 preferably has a water vapor transmission rate of not more than 10⁻² g·m⁻²·day⁻¹ to allow the gas barrier member 100 to have an enough gas barrier property.

The first film 60 preferably has a light transmission property. For example, the first film 60 preferably has a transmittance of not less than 80% at a measurement wavelength of 550 nm, more preferably has a transmittance of not less than 90% at the measurement wavelength of 550 nm.

The thickness of the first film 60 is preferably in a range of 5 nm to 20 µm. In this context, the thickness of the first film 60 means an average value of distances from the bottom surface of the first film 60 to the surface in which the concave-convex pattern 80 is formed.

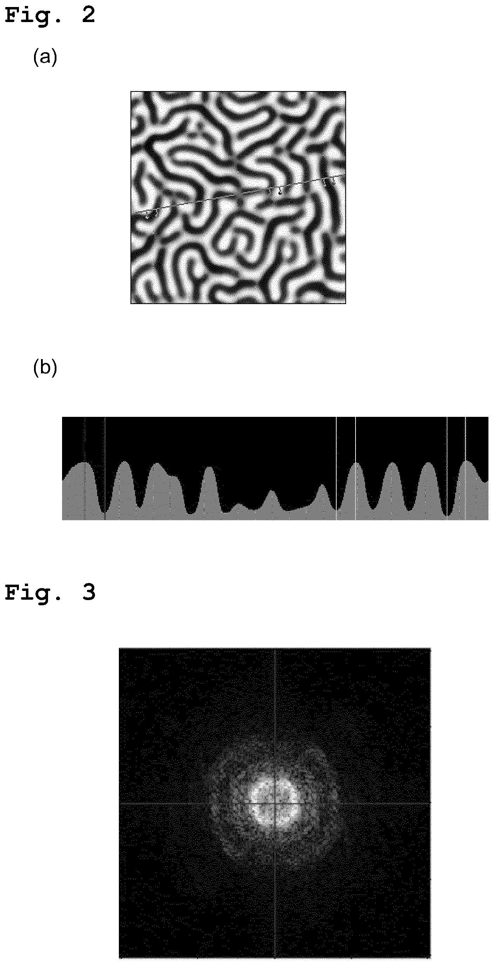

The surface of the first film 60 has the fine or minute concave-concave pattern (concave-convex structure) 80. The fine concave-convex pattern 80 may be any pattern such as a pattern having a lens structure, a structure having a light diffusion function or a light diffraction, or the like. Fig. 2(a) is an exemplary schematic plan view of the concave-convex pattern 80 of the first film 60, and Fig. 2(b) is a cross-section profile taken along the cutting-plane line in Fig. 2(a). As depicted in Fig. 2(b), the cross-sectional shape of the first film 60 may be formed by relatively gentle inclined surfaces and may construct a waveform (in the present application, referred to as "waveform structure" as appropriate) upward from the base member 40. Namely, convexities of the concave-convex pattern 80 may have a cross-sectional shape which is narrowing from the base portion, of each convexity, located on the side of the base member 40 toward the apex portion of each convexity. The concave-convex pattern 80 of the first film 60 may have such a characteristic that, as in Fig. 2(a) depicting an exemplary schematic plane view of the concave-convex pattern 80, convexities (white portions) and concavities (black portions) have an elongated shape extending while winding (waving, meandering), and that the convexities and the concavities in the concave-convex pattern 80 have the extending directions, winding direction (bending directions) and extending lengths which are irregular in a plane view. Such a concave-convex pattern 80 is clearly different from a regularly arranged pattern such as stripe, waved stripe, zigzag, etc., or a regularly arranged pattern such as dot-shaped pattern, etc., and the concave-convex pattern 80 can be distinguished, in view of this point, from a pattern, such as a circuit pattern, which has a regularity and/or many linear portions or straight lines, etc. Since the first film 60 has the above-described characteristics, when the first film 60 is cut in any plane perpendicular to the surface of the base member 40, the concave-convex cross-section consequently appears repeatedly. Further, a part (portion) or the entirety of convexities and the concavities of the concave-convex pattern 80 may be branched at an intermediate portion thereof, in a plane view (see Fig. 2(a)). In Fig. 2(a), the pitch of the convexities appears to be uniform as a whole. Further, in the concave-convex pattern 80, the concavities may be defined by the convexities, and may extend along the convexities.

In addition to the irregular concave-convex pattern as described above, the concave-convex pattern 80 may be any pattern having a dot structure; a prism structure; a stripe structure formed by lines and spaces; a pillar structure formed by cylindrical shaped structures, conical shaped structures, truncated cone shaped structures, triangle pole shaped structures, triangular pyramid shaped structures, truncated triangular pyramid shaped structures, square pole shaped structures, quadrangular pyramid shaped structures, truncated quadrangular pyramid shaped structures, polygonal column shaped structures, polygonal pyramid shaped structures, truncated polygonal pyramid shaped structures, or the like; a hole structure; a micro lens array structure; or a structure having a function such as light diffusion and/or diffraction. Further, the concave-convex pattern 80 may be an irregular minute concave-convex pattern formed by a sandblasting method.

In order that the concave-convex pattern 80 of the first film 60 functions as the diffraction grating, the average pitch of concavities and convexities is preferably in a range of 100 to 1500 nm. When the average pitch of concavities and convexities is less than the lower limit, pitches are so small relative to wavelengths of visible light that the diffraction of light by concavities and convexities is less likely to occur. On the other hand, when the average pitch exceeds the upper limit, the diffraction angle is so small that functions as the diffraction grating are more likely to be lost. The average pitch of concavities and convexities is more preferably in a range of 200 to 1200 nm. The average value of the depth distribution of concavities and convexities is preferably in a range of 20 to 200 nm. When the average value of the depth distribution of concavities and convexities is less than the lower limit, the depth is so small relative to wavelengths of visible light that the required diffraction is less likely to occur. On the other hand, when the average value of the depth distribution of concavities and convexities exceeds the upper limit, intensity of diffracted light is likely to become non-uniform, which in turn may lead to the following situation when an organic EL element is produced by using the gas barrier member 100. For example, an electric field distribution in an organic layer of the organic EL element becomes non-uniform to cause the electric field to concentrate on a certain position or area in the organic layer, thus causing any leak current to be easily generated, and/or shortening a service life of the organic EL element. The average value of the depth distribution of concavities and convexities is more preferably in a range of 30 to 150 nm. The standard deviation of the depth of convexities and concavities is preferably in a range of 10 to 100 nm. When the standard deviation of depth of convexities and concavities is less than the lower limit, the depth is so small relative to wavelengths of visible light that the required diffraction is less likely to occur. On the other hand, when the standard deviation of depth of convexities and concavities exceeds the upper limit, intensity of diffracted light is likely to become non-uniform, which in turn may lead to the following situation when an organic EL element is produced by using the gas barrier member 100. For example, an electric field distribution in an organic layer of the organic EL element becomes non-uniform to cause the electric field to concentrate on a certain position or area in the organic layer, thus causing any leak current to be easily generated, and/or shortening a service life of the organic EL element. The standard deviation of depth of convexities and concavities is more preferably in a range of 15 to 75 nm.

Note that the term "average pitch of concavities and convexities" in the present application means an average value of the pitch of concavities and convexities in a case of measuring the pitch of concavities and convexities (spacing distance between adjacent convex portions or spacing distance between adjacent concave portions) in a surface on which the convexities and concavities are formed. Such an average value of the pitch of concavities and convexities can be obtained as follows. Namely, a concavity and convexity analysis image is obtained by measuring the shape of concavities and convexities on the surface by using a scanning probe microscope (for example, a scanning probe microscope manufactured by Hitachi High-Tech Science Corporation, under the product name of "E-sweep", etc.), under the following measurement conditions, then the distances between randomly selected concave portions or convex portions adjacent to each other are measured at not less than 100 points in the concavity and convexity analysis image, and then the average of the distances is arithmetically calculated and is determined as the average pitch of concavities and convexities. The measurement conditions are as follows:
Measurement mode: cantilever intermittent contact mode
Material of the cantilever: silicon
Lever width of the cantilever: 40 µm
Diameter of tip of chip of the cantilever: 10 nm

Further, in the present application, the average value of the depth distribution of concavities and convexities and the standard deviation of the depth of concavities and convexities can be calculated by the following manner. Namely, a concavity and convexity analysis image is obtained by measuring the shape of concavities and convexities on the surface by using a scanning probe microscope (for example, a scanning probe microscope manufactured by Hitachi High-Tech Science Corporation, under the product name of "E-sweep", etc.), in a randomly selected measurement region of 3 µm square (vertical: 3 µm, horizontal: 3 µm) or in a randomly selected measurement region of 10 µm square (vertical: 10 µm, horizontal: 10 µm) under the above-described conditions. When doing so, data of height of concavities and convexities at not less than 16,384 points (vertical: 128 points x horizontal: 128 points) are obtained within the measurement region, each in nanometer scale. Note that although the number of measurement points is different depending on the kind and setting of the measuring device which is used, for example in a case of using the above-described scanning probe microscope manufactured by Hitachi High-Tech Science Corporation, under the product name of "E-sweep", it is possible to perform the measurement at measurement points of 65,536 points (vertical: 256 points x horizontal: 256 points; namely, the measurement in a resolution of 256 x 256 pixels) within the measurement region of 3 µm square. With respect to the height of concavities and convexities (unit: nm) measured in such a manner, at first, a measurement point "P" is determined, among all the measurement points, which is the highest from the surface of a base member. Then, a plane which includes the measurement point P and is parallel to the surface of the base member is determined as a reference plane (horizontal plane), and a depth value from the reference plane (difference obtained by subtracting, from the value of height from the base member at the measurement point P, the height from the base member at each of the measurement points) is obtained as the data of depth of concavities and convexities. Note that such a depth data of concavities and convexities can be obtained, for example, by performing automatic calculation with software in the measurement device (for example, the above-described scanning probe microscope manufactured by Hitachi High-Tech Science Corporation, under the product name of "E-sweep"), and the value obtained by the automatic calculation in such a manner can be utilized as the data of depth of concavities and convexities. After obtaining the data of depth of concavity and convexity at each of the measurement points in this manner, the values, which can be calculated by obtaining the arithmetic average value and the standard deviation of the obtained data of depth of concavity and convexity, are adopted as the average value of the depth distribution of concavities and convexities and the standard deviation of the depth of concavities and convexities. In this specification, the average pitch of concavities and convexities, the average value of the depth distribution of concavities and convexities, and the standard deviation of depth of concavities and convexities can be obtained via the above-described measuring method, regardless of the material of the surface on which concavities and convexities are formed.

The concave-convex pattern 80 may be a such a quasi-periodic pattern in which a Fourier-transformed image, obtained by performing a two-dimensional fast Fourier-transform processing on a concavity and convexity analysis image obtained by analyzing a concave-convex shape on the surface, shows a circular or annular pattern as depicted in Fig. 3, namely, such a quasi-periodic pattern in which, although concavities and convexities have no particular orientation (directionality), the pattern has the distribution of pitches of concavities and convexities (pitches of concavities and convexities vary). Therefore, a gas barrier member having such a quasi-periodic pattern is suitable for a diffraction substrate used in a surface-emitting element, such as the organic EL element, provided that the gas barrier member has concavities and convexities of which pitch distribution or pitch variability enables the gas barrier member to diffract visible light.

As depicted in Fig. 3, the Fourier-transformed image may show a circular or annular pattern substantially centered at an origin at which an absolute value of wavenumber is 0 µm⁻¹, and the circular or annular pattern may be present within a region where the absolute value of wavenumber is in a range of not more than 10 µm⁻¹ (more preferably in a range of 0.667 to 10 µm⁻¹, further preferably in a range of 0.833 to 5 µm⁻¹). The circular pattern of the Fourier-transformed image is a pattern observed due to gathering of bright spots in the Fourier-transformed image. The term "circular" herein means that the pattern of the gathering of bright spots looks like a substantially circular shape, and is a concept further including a case where a part of the contour of the circular pattern looks like a convex shape or a concave shape. The pattern of the gathering of bright spots may look like a substantially annular shape, and this case is expressed as the term "annular". It is noted that the term "annular" is a concept further including a case where a shape of an outer circle or inner circle of the ring looks like a substantially circular shape and a case where a part of the contour of the outer circle or the inner circle of the ring looks like a convex shape or a concave shape. Further, the phrase "the circular or annular pattern is present within a region where the absolute value of wavenumber is not more than 10 µm⁻¹ (more preferably in a range of 0.667 to 10 µm⁻¹, further preferably in a range of 0.833 to 5 µm⁻¹)" means that not less than 30% (more preferably not less than 50%, further preferably not less than 80%, and particularly preferably not less than 90%) of bright spots forming the Fourier-transformed image are present within the region where the absolute value of wavenumber is not more than 10 µm⁻¹ (more preferably in the range of 0.667 to 10 µm⁻¹, and further preferably in the range of 0.833 to 5 µm⁻¹). Regarding the relationship between the concave-convex pattern and the Fourier-transformed image, the followings have been revealed. Namely, when the concave-convex pattern itself has neither the pitch distribution nor the directivity, the Fourier-transformed image appears to have a random pattern (no pattern). On the other hand, when the concave-convex pattern is entirely isotropic in an XY direction but has the pitch distribution, a circular or annular Fourier-transformed image appears. Further, when the concave-convex pattern has a single pitch, the annular shape appeared in the Fourier-transformed image tends to be sharp.

The two-dimensional fast Fourier transform processing on the concavity and convexity analysis image can be easily performed by electronic image processing by using a computer equipped with software for the two-dimensional fast Fourier transform processing.

Although Fig. 1(a) depicts a structure in which the first gas barrier layer is formed only of the first film 60, that is, a structure in which the first gas barrier layer is formed by the first film 60 as a single layer, the first gas barrier layer may be formed by a multilayer film including the first film 60 and at least one film that is different from the first film 60 and disposed under the first film 60 (on a side, of the first film 60, facing the base member 40, namely a position between the first film 60 and the second film 70). The at least one film different from the first film 60 and disposed under the first film 60 may be made from an inorganic material, an organic material, or a material in which an ultraviolet absorbent material is included in the inorganic material or the organic material, and examples of the inorganic material and the organic material are the same as those listed as the materials that may be used for the first film 60. A stress relaxation layer may be provided between respective layers. Those usable for the stress relaxation layer include, for example, various resins such as monomers, oligomers, and polymers of those based on epoxy, acrylic, methacrylic, vinyl ether, oxetane, urethane, melamine, urea, polyester, polyolefin, phenol, cross-linking type liquid crystal, fluorine, silicone, polyamide, etc.

When the gas barrier member, of which first gas barrier layer is formed as the multilayer film, is used as an optical substrate of the light emitting element, the first gas barrier layer preferably has a light transmission property. The first gas barrier layer preferably has a transmittance of not less than 80% at a measurement wavelength of 550 nm, more preferably has a transmittance of not less than 90% at the measurement wavelength of 550 nm.

When the first gas barrier layer is formed as the multilayer film, the thickness of the first gas barrier layer is preferably in a range of 5 nm to 20 µm. In this context, the thickness of the first gas barrier layer means an average value of distances from the bottom surface of the first gas barrier layer to the surface in which the concave-convex pattern 80 is formed.

When the first gas barrier layer is formed as the multilayer film, the water vapor transmission rate of the first gas barrier layer is preferably not more than 10⁻² g·m⁻²·day⁻¹ to allow the gas barrier member 100 to have an enough gas barrier property. In that case, the water vapor transmission rate of the first film may exceed 10⁻² g·m⁻²·day⁻¹.

### <Second film>

In the gas barrier member 100, the second member 70 is formed, as the second gas barrier layer, between the base member 40 and the first firm 60. As the material for the second film 70, it is possible to use any of the inorganic materials and the organic materials (resin materials) listed as the materials that may be used for the first film 60, and a material in which an ultraviolet absorbent material is included in the inorganic material or the organic material.

When the gas barrier member 100 is used as an optical substrate of the light emitting element, the second film 70 preferably has a light transmission property. For example, the second film 70 preferably has a transmittance of not less than 80% at a measurement wavelength of 550 nm, more preferably has a transmittance of not less than 90% at the measurement wavelength of 550 nm.

The thickness of the second film 70 is preferably in a range of 5 nm to 20 µm.

Although Fig. 1(a) depicts a structure in which the second gas barrier layer is formed by the second film 70 as a single layer, the second gas barrier layer may be formed by a multilayer film including the second film 70 and at least one film that is different from the second film 70. The at least one film different from the second film 70 may be made from any of those listed as the materials that may be used for the second film 70. A stress relaxation layer may be provided between respective layers.

When the gas barrier member, of which second gas barrier layer is formed as the multilayer film, is used as an optical substrate of the light emitting element, the second gas barrier layer preferably has a light transmission property. The second gas barrier layer preferably has a transmittance of not less than 80% at a measurement wavelength of 550 nm, more preferably has a transmittance of not less than 90% at the measurement wavelength of 550 nm.

When the second gas barrier layer is formed as the multilayer film, the thickness of the second gas barrier layer is preferably in a range of 5 nm to 20 µm.

When the second gas barrier layer is formed as the multilayer film, the water vapor transmission rate of the second gas barrier layer is preferably not more than 10⁻² g·m⁻²·day⁻¹ to allow the gas barrier member to have an enough gas barrier property. In that case, the water vapor transmission rate of the second film may exceed 10⁻² g·m⁻²·day⁻¹.

### <Adhesive layer>

The gas barrier member may be the gas barrier member 100a as depicted in Fig. 1(b) including the adhesive layer 30 between the first film 60 and the second film 70. That is, the first film 60 and the second film 70 may be joined via the adhesive layer 30. The thickness of the adhesive layer 30 is preferably in a range of 500 nm to 20 µm.

As the material of the adhesive layer 30, it is allowable to use, without any restriction, any adhesive which is generally used for glass or a plastic substrate, etc., and which is exemplified, for example, by polyvinyl acetate-based adhesive; photo-curable and thermo-curable acrylic-based adhesives having a reactive vinyl group such as acrylic acid-based oligomer, methacrylic acid-based oligomer, etc.; epoxy resin adhesive; moisture-curable adhesive such as 2-cyanoacrylic acid ester; ethylene copolymer-based adhesive; polyester-based adhesive; polyimide-based adhesive; amino resin-based adhesive composed of urea resin, melamine resin, or the like; phenolic resin-based adhesive; polyurethane-based adhesive; reactive (meth)acrylic-based adhesive; rubber-based adhesive; vinyl ether-based adhesive; silicone-based adhesive; etc. Among those adhesives, preferable adhesives include the acrylic-based adhesive, the epoxy-based adhesive, etc., among which the epoxy-based adhesive of which contraction (shrinkage) during the curing is small is particularly preferable. When the gas barrier member 100a is used as an optical element of the organic EL element or the like, the adhesive layer 30 may be made from any of the materials that may be used for the sealing material of the organic EL element.

The epoxy-based adhesives include, for example, an epoxy resin composition made from an epoxy resin and a curing agent. The adhesive force of the epoxy resin composition is generated by its curing reaction which is brought about by mixing a compound containing an epoxy group with the curing agent containing amines and acid anhydride. The epoxy-based adhesives usable in the present embodiment are exemplified, for example, by Cemedine EP-001 produced by CEMEDINE CO., LTD.; 3950, 3951 and 3952 of 3950 series, 2083, 2086 and 2087 of 2080 series, and 2230 and 2230B of 2230 series, and 3124C produced by THREEBOND HOLDINGS CO., LTD.; MOS07 and MOS10 of Bond MOS series produced by KONISHI CO., LTD.; ULTIGHT 1540 and the like of ULTIGHT 1500 series produced by TOHO KASEI CO., LTD.; and XNR5576/5576LV, XNR5516/5516HV/5516Z, XNR5570, T470/UR7116, T470/UR7134, T470/UR7132, and T470/UR7124E-LV produced by NAGASE CHEMTEX CORPORATION; NOA81 produced by Norland Products Inc.; KR-508 produced by ADECA CORPORATION; and CELVENUS-HBF series and CELVENUS-HRF series produced by Daicel Corporation.

The acrylic-based adhesives include, for example, an adhesive containing an acrylic-based pressure-sensitive adhesive component, an energy-ray curable component and a thermo-curable adhesive component. The acrylic-based adhesives usable in the present embodiment are exemplified, for example, by 3003, 3027B, 3033B, 3042B, and the like produced by THREEBOND HOLDINGS CO., LTD.; Cemedine Y600 and Cemedine Y600H produced by CEMEDINE CO., LTD.; and WORLD ROCK No. 0555 and the like produced by KYORITSU CHEMICAL & CO., LTD.

Other than the those listed above, the rubber-based adhesives include, for example, one obtained in such a manner that adhesive elastomer, an adhesion-imparting agent, a softening agent, and the like are mixed with one another. The adhesive elastomer is at least one kind of adhesive elastomer selected, for example, from natural rubber composed mainly of cis-1,4-polyisoprene; synthetic rubber composed mainly of styrene-butadiene rubber (SBR), polyisobutylene, butyl rubber, and the like; and block rubber composed mainly of styrene-butadiene-styrene copolymer rubber (SBS), styrene-isoprene-styrene copolymer rubber (SIS), and the like. The adhesion-imparting agent is a thermoplastic resin containing an amorphous oligomer (middle-molecular weight polymer of a dimer or more), the amorphous oligomer being a liquid or solid at normal temperature and having a molecular weight in a range of hundreds to about ten thousand, such as a rosin-based resin, a terpene-based resin, a petroleum resin, and a chroman-indene resin. The softening agent is exemplified, for example, by mineral oil, liquid polybutene, liquid polyisobutylene, and liquid polyacrylic ester.

Examples of vinyl ether-based adhesives include an adhesive composed of a homopolymer such as vinyl methyl ether, vinyl ethyl ether or vinyl isobutyl ether, an adhesive composed of a copolymer of acrylate and vinyl ether such as vinyl methyl ether, vinyl ethyl ether or vinyl isobutyl ether (adhesive elastomer), and the like. Each of the above-described vinyl ether-based adhesives may be mixed with the above-described adhesion-imparting agent, softening agent, or the like.

Examples of silicone-based adhesives include one obtained in such a manner that a polymer (or adhesive elastomer) containing a residual silanol group (SiOH) at an end of a polymer chain is mixed with the above-described adhesion-imparting agent, softening agent, or the like. The polymer containing a residual silanol group is represented by polydimethylsiloxane or polydimethyldiphenylsiloxane having high molecular weight.

For example, XNR5516Z produced by NAGASE & CO., LTD.; TB3124 produced by THREEBOND HOLDINGS CO., LTD.; CELVENUS H001 produced by Daicel Corporation; or the like may be used as the material of the sealing material of the organic EL element.

### [First embodiment of method for manufacturing gas barrier member]

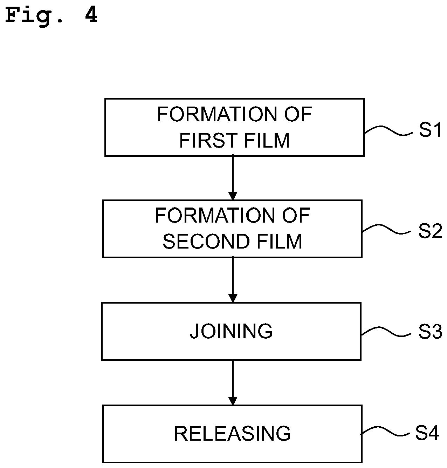

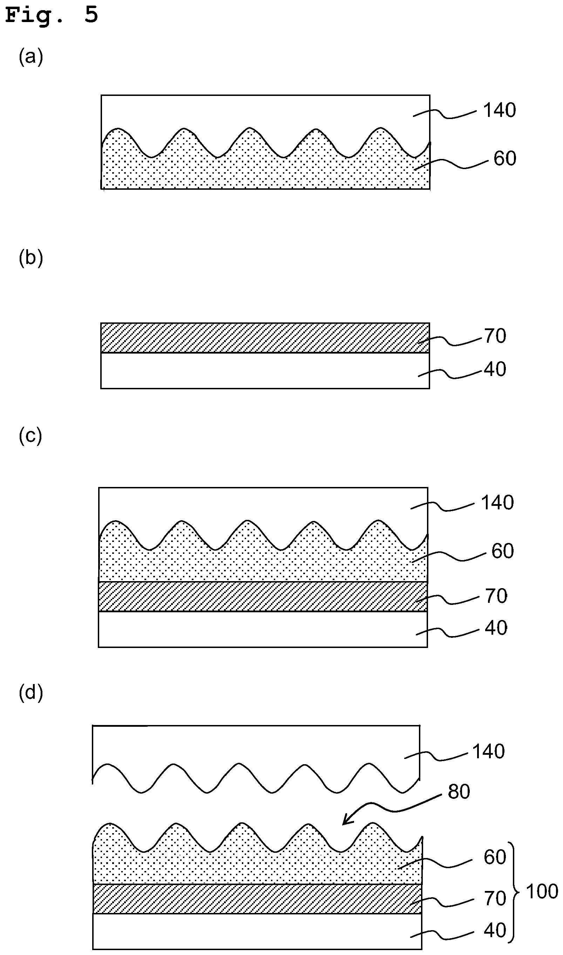

An explanation will be made about the first embodiment of the method for manufacturing the gas barrier member. As indicated in Fig. 4, the method for manufacturing the gas barrier member mainly includes a step S1 for forming the first film on a concave-convex pattern of a mold; a step S2 for forming the second film on the base member; a step S3 for joining the first film and the second film; and a step S4 for releasing the mold from the first film. In the following, the mold with the concave-convex pattern and a method for manufacturing the mold will be explained first, and then the steps S1 to S4 will be explained in that order with reference to Figs. 5(a) to 5(d).

### <Mold with concave-convex pattern>

The mold used in the method for manufacturing the gas barrier member according to the first embodiment has the concave-convex pattern corresponding to the above-described concave-convex pattern of the first film (concave-convex pattern obtained by inverting the concave-convex pattern of the first film). For example, the concave-convex pattern of the mold may be a such a quasi-periodic pattern in which a Fourier-transformed image, obtained by performing a two-dimensional fast Fourier-transform processing on a concavity and convexity analysis image obtained by analyzing a concave-convex shape, shows a circular or annular pattern, namely, such a quasi-periodic pattern in which, although concavities and convexities have no particular orientation (directionality), the pattern has the distribution of pitches of concavities and convexities (pitches of concavities and convexities vary). The Fourier-transformed image may show a circular or annular pattern substantially centered at an origin at which an absolute value of wavenumber is 0 µm⁻¹, and that the circular or annular pattern may be present within a region where the absolute value of wavenumber is in a range of not more than 10 µm⁻¹ (more preferably in a range of 0.667 to 10 µm⁻¹, further preferably in a range of 0.833 to 5 µm⁻¹). Examples of the mold having such a concave-convex pattern include a metal mold and a film-shaped resin mold produced in a method as will be described later on. The resin forming the resin mold includes rubber such as natural rubber or synthetic rubber.

An explanation will be given about an exemplary method for producing the mold. A master block pattern for forming the concave-convex pattern of the mold is produced first. For example, when a gas barrier member having a concave-convex pattern composed of curved line-shaped convexities and concavities extending in non-uniform directions is manufactured, it is suitable that the master block is formed by a method of utilizing the self-organization or self-assembly (micro phase separation) of a block copolymer by heating, as described in International Publication No. WO2012/096368 of the applicants of the present invention (hereinafter referred to as "BCP (Block Copolymer) thermal annealing method" as appropriate), or a method of utilizing the self-organization or self-assembly of a block copolymer under a solvent atmosphere, as described in International Publication No. WO2013/161454 of the applicants of the present invention (hereinafter referred to as "BCP solvent annealing method" as appropriate), or a method of heating and cooling a vapor deposited film on a polymer film to form concavities and convexities of wrinkles on a surface of polymer, as disclosed in International Publication No. WO2011/007878 A1 of the applicants of the present invention (hereinafter referred to as "BKL (Buckling) method" as appropriate). When the pattern is formed by the BCP thermal annealing method or the BCP solvent annealing method, although any material can be used as the material for forming the pattern, the material is preferably a block copolymer composed of a combination of two selected from the group consisting of: a styrene-based polymer such as polystyrene; polyalkyl methacrylate such as polymethyl methacrylate; polyethylene oxide; polybutadiene; polyisoprene; polyvinylpyridine; and polylactic acid. The pattern formed by the self-organization of these materials preferably has a horizontal cylinder structure (structure wherein cylinders are oriented horizontally relative to a base material) as described in WO2013/161454, or a vertical lamella structure (structure in which lamellae are oriented vertically relative to a base material) as described in "Macromolecules" 2014, Vol. 47, pp. 2, among which the vertical lamella structure is more preferable for a case of forming deeper concavities and convexities. Further, the concave-convex pattern obtained by the solvent annealing process may be subjected to etching by irradiation with energy rays represented by ultraviolet rays such as excimer UV light, or etching by a dry etching method such as RIE (reactive ion etching) or ICP etching. Furthermore, the concave-convex pattern that has been subjected to such an etching may be subjected to the heating process. Moreover, based on the concave-convex pattern formed by the BCP thermal annealing method or the BCP solvent annealing method, it is possible to form a concave-convex pattern in which concavities and convexities have further deeper depth, with a method as described in "Advanced Materials" 2012, vol. 24, pp. 5688-5694, "Science", vol. 322, pp. 429 (2008), etc. Namely, abase material layer including SiO₂, Si, etc. is coated with a block copolymer, and a self-organization structure of the block copolymer is formed by the BCP thermal annealing method or the BCP solvent annealing method. Then, one of the segments of the block copolymer is selectively etched away. The other segment, as the remaining segment, is used as a mask to perform etching for the base material layer, thereby forming a groove (concavity or concave portion) having a desired depth in the base material layer.

Instead of using the above-described BCP thermal annealing method, the BKL method and the BCP solvent annealing method, the photolithography method may be used to form the concave-convex pattern. Other than these, the concave-convex pattern of the master block can be produced by any method including, for example, microfabrication or fine-processing methods such as a cutting (cutting and processing) or machining method, an electron-beam direct imaging method, a particle beam processing method, and a scanning probe processing method; a fine-processing method using the self-organization or self-assembly of fine particles; and a sandblasting method. In a case of manufacturing a member (gas barrier member) with a concave-convex pattern composed of linear or curved-shaped convexities and concavities extending in a uniform direction by use of the mold, each of the above methods may be used to form a master block with the concave-convex pattern composed of the linear or curved-shaped convexities and concavities extending in the uniform direction.

After forming the master block with the concave-convex pattern by means of the BCP thermal annealing method, the BKL method or the BCP solvent annealing method, etc., further, a mold to which the pattern is transferred can be formed by an electroforming method or the like, as follows. At first, a seed layer functioning as an electroconductive layer for an electroforming process can be formed on the master block, which has the pattern thereon, by means of non-electrolytic plating, sputtering, vapor deposition, or the like. The thickness of the seed layer is preferably not less than 10 nm to uniformize a current density during the subsequent electroforming process, and thereby making the thickness of a metal layer accumulated by the subsequent electroforming process be uniform. As the material of the seed layer, it is possible to use, for example, nickel, copper, gold, silver, platinum, titanium, cobalt, tin, zinc, chrome, gold-cobalt alloy, gold-nickel alloy, boron-nickel alloy, solder, copper-nickel-chromium alloy, tin-nickel alloy, nickel-palladium alloy, nickel-cobalt-phosphorus alloy, or alloy thereof. Subsequently, a metal layer is accumulated on the seed layer by the electroforming (electroplating). The entire thickness of the metal layer including the thickness of the seed layer can be, for example, in a range of 10 µm to 30,000 µm. As the material of the metal layer accumulated by the electroforming, it is possible to use any of the metal species as described above which can be used as the seed layer. Considering ease of the subsequent processes for forming the mold such as pressing with respect to the resin layer, releasing (peeling-off), and cleaning (washing), the formed metal layer desirably has appropriate hardness and thickness.

The metal layer including the seed layer obtained as described above is released (peeled off) from the master block having the concave-convex structure to obtain a metal substrate. The metal substrate may be peeled off from the master block physically. Alternatively, the materials composing the pattern of the master block may be dissolved to be removed by using an organic solvent dissolving them, such as toluene, tetrahydrofuran (THF), and chloroform, such that the metal substrate can be peeled off from the master block. When the metal substrate is peeled off from the master block, a remaining material component on the metal substrate can be removed by cleaning. As the cleaning method, it is possible to use wet cleaning using a surfactant etc., or dry cleaning using ultraviolet rays and/or plasma. Alternatively, for example, it is allowable to use an adhesive agent or a bonding agent such that the remaining material component is caused to attach or adhere to the adhesive agent or the bonding agent then is removed. Accordingly, the metal substrate (metal mold) which can be obtained in such a manner and to which the pattern has been transferred from the master block may be used as the mold for concave-convex pattern transfer of the present embodiment.

Further, a flexible mold such as a film-shaped mold can be produced by using the obtained metal substrate and by transferring the concave-convex structure (pattern) of the obtained metal substrate to a film-shaped supporting substrate. For example, after the supporting substrate is coated with the curable resin to form a resin layer, the resin layer is cured while the concave-convex structure of the metal substrate is being pressed against the resin layer. The supporting substrate is exemplified, for example, by base members made from inorganic materials such as glass, quartz (quartz glass), silicon, etc.; base members made from organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), polyarylate, etc.; and metallic materials such as nickel, copper, aluminum, etc. The thickness of the supporting substrate may be in a range of 1 µm to 500 µm.

The curable resin can be exemplified by various resins including, for example, monomers, oligomers, and polymers of those based on epoxy, acryl, methacryl, vinyl ether, oxetane, urethane, melamine, urea, polyester, polyolefin, phenol, cross-linking type liquid crystal, fluorine, silicone, polyamide, etc. The thickness of the curable resin is preferably in a range of 0.5 µm to 500 µm. When the thickness is less than the lower limit, heights of the concavities and convexities formed on the surface of the cured resin layer are likely to be insufficient. On the other hand, when the thickness exceeds the upper limit, the influence of volume change of the resin upon curing is likely to be so large that there is such a possibility that the formation of the shape of the concavities and convexities might be unsatisfactory.

As a method for coating the supporting substrate with the curable resin, it is possible to adopt, for example, various coating methods such as the spin coating method, spray coating method, dip coating method, dropping method, gravure printing method, screen printing method, relief printing method, die coating method, curtain coating method, ink-jet method, and sputtering method. Further, although the condition for curing the curable resin varies depending on the kind of the resin to be used, the curing temperature is preferably for example in a range of the room temperature to 250°C, and the curing time is preferably in a range of 0.5 minute to 3 hours. Alternatively, a method may be employed in which the curable resin is cured by being irradiated with energy ray such as ultraviolet light or electron beam. In such a case, the amount of the irradiation is preferably in a range of 20 mJ/cm² to 5 J/cm².

Subsequently, the metal substrate is detached from the curable resin layer after the curing. The method for detaching the metal substrate is not limited to a mechanical releasing (exfoliating or peeling off) method, and a publicly known method can be adopted. Accordingly, a film-shaped resin mold, which can be obtained in such a manner and which has the cured resin layer having the concavities and convexities and formed on the supporting substrate, may be used as the mold for concave-convex pattern transfer of the present embodiment.

Further, it is possible to coat the concave-convex structure (pattern) of the metal substrate obtained in the above-described manner with a rubber-based resin material, to cure the coated resin material, and to release the cured resin material from the metal substrate, so as to manufacture a rubber mold having the concave-convex pattern of the metal substrate transferred thereto. The obtained rubber mold may be used as the mold for concave-convex pattern transfer of the present embodiment. Silicone rubber or a mixture or copolymer of silicone rubber and another material is particularly preferably used as the rubber-based resin material. The usable silicone rubber is exemplified, for example, by polyorganosiloxane, cross-linking type polyorganosiloxane, a polyorganosiloxane/polycarbonate copolymer, a polyorganosiloxane/polyphenylene copolymer, a polyorganosiloxane/polystyrene copolymer, polytrimethyl-silylpropyne, poly-4-methyl pentene, etc. The silicone rubber is more inexpensive than other resin materials; has superior heat resistance, high heat conductivity, and elasticity; and the silicone rubber is less likely to be deformed under a high temperature condition. Thus, the silicone rubber is suitable for the transfer process for concave-convex pattern under the high temperature condition. Further, since the silicone rubber-based material has high permeability of gas and water vapor, a solvent and water vapor of a material to be subjected to transfer can go through or permeate the silicone rubber material easily. Therefore, the silicone rubber-based material is suitable for such a case of using the rubber mold for the purpose of transferring the concave-convex pattern to a film of a solution of a precursor of the inorganic material, as described later. Further, the surface free energy of rubber-based material is preferably not more than 25 mN/m. With this, it is possible to obtain a superior mold-releasing property during the transfer of the concave-convex pattern of the rubber mold to the coating film on the base member, thereby making it possible to prevent any transfer failure. The rubber mold may have, for example, a length in a range of 50 mm to 1000 mm, a width in a range of 50 mm to 3000 mm, and a thickness in a range of 1 mm to 50 mm. Further, a mold-release treatment may be performed on the surface of the concave-convex pattern of the rubber mold as needed.

### <First film formation step>

In the method for manufacturing the gas barrier member of the first embodiment, as depicted in Fig. 5(a), the first film 60 is firstly formed, as the first gas barrier layer, on a concave-convex pattern of a mold 140 having the above-described concave-convex pattern (step S1 of Fig. 4).

The first film 60 may be formed by a wet process. The "wet process" in the present application includes, for example, a method of coating the mold with the precursor of the inorganic material and curing the coating film; a method of coating the mold with a dispersion liquid of fine particles and drying the coating film; a method of coating the mold with a resin material and curing the coating film; and a liquid phase deposition (LPD) method. The film formed by any of these wet process may contain an ultraviolet absorbent material.

For example, when the first film 60 is formed by the method of coating the mold with the precursor of the inorganic material and curing the coating film, alkoxide or the like, such as silicon alkoxide or titanium alkoxide, may be used as the precursor of the inorganic material (sol-gel method). Alternatively, polysilazane may be used as the precursor of the inorganic material. The polysilazane is oxidized by being heated or being irradiated with an energy ray such as excimer, is thereby ceramicized (subjected to silica reforming or modification) and forms silica, SiN or SiON. Note that the "polysilazane" is a polymer having a silicon-nitrogen bond, is an inorganic polymer comprising Si-N, Si-H, N-H, or the like, and is a precursor of a ceramics such as SiO₂, Si₃N₄, or SiO_{X}N_{Y}, which is an intermediate solid solution of such a ceramics. A compound, which is ceramized at relatively low temperature and is modified into silica or the like, as that represented by the following general formula (1) described in Japanese Patent Application Laid-open No. H08-112879, is more preferable.

General formula (1): -Si (R1) (R2)-N (R3)-

In the general formula (1), R1, R2, and R3 each represent a hydrogen atom, an alkyl group, an alkenyl group, a cycloalkyl group, an aryl group, an alkylsilyl group, an alkylamino group, or an alkoxy group.

Among the compounds represented by the general formula (1), perhydropolysilazane (referred to also as PHPS) in which all of R1, R2, and R3 are hydrogen atoms and organopolysilazane in which a part of the hydrogen bonded to Si thereof is substituted by, for example, an alkyl group are particularly preferable.

As other examples of the polysilazane ceramized at low temperature, it is also possible to use: silicon alkoxide-added polysilazane obtained by reacting polysilazane with silicon alkoxide (for example, Japanese Patent Laid-Open No. 5-238827); glycidol-added polysilazane obtained by reaction with glycidol (for example, Japanese Patent Laid-open No. 6-122852); alcohol-added polysilazane obtained by reaction with alcohol (for example, Japanese Patent Laid-open No. 6-240208); metal carboxylate-added polysilazane obtained by reaction with metal carboxylate (for example, Japanese Patent Laid-Open No. 6-299118); acetylacetonato complex-added polysilazane obtained by reaction with an acetylacetonato complex containing a metal (for example, Japanese Patent Laid-Open No. 6-306329); metallic fine particles-added polysilazane obtained by addition of metallic fine particles (for example, Japanese Patent Laid-Open No. 7-196986), and the like.

As the solvent of the polysilazane solution, it is possible to use hydrocarbon solvents such as aliphatic hydrocarbons, alicyclic hydrocarbons, and aromatic hydrocarbons; halogenated hydrocarbon solvents; and ethers such as aliphatic ethers and alicyclic ethers. Amine or a metal catalyst may be added in order to promote the modification into a silicon oxide compound.

The following describes an example in which the first film 60 made from the inorganic material is formed by the sol-gel method. At first, metal alkoxide as the precursor is prepared. For example, when the first film 60 made from silica is formed, those usable as the silica precursor include, for example, tetraalkoxide monomers represented by tetraalkoxysilane such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, and tetra-t-butoxysilane; trialkoxide monomers represented by trialkoxysilane such as methyltrimethoxysilane, ethyltrimethoxysilane, propyltrimethoxysilane, isopropyltrimethoxysilane, phenyltrimethoxysilane, methyltriethoxysilane (MTES), ethyltriethoxysilane, propyltriethoxysilane, isopropyltriethoxysilane, phenyltriethoxysilane, methyltripropoxysilane, ethyltripropoxysilane, propyltripropoxysilane, isopropyltripropoxysilane, phenyltripropoxysilane, methyltriisopropoxysilane, ethyltriisopropoxysilane, propyltriisopropoxysilane, isopropyltriisopropoxysilane, phenyltriisopropoxysilane, and tolyltriethoxysilane; and dialkoxide monomers represented by dialkoxysilane such as dimethyldimethoxysilane, dimethyldiethoxysilane, dimethyldipropoxysilane, dimethyldiisopropoxysilane, dimethyldi-n-butoxysilane, dimethyldi-i-butoxysilane, dimethyldi-sec-butoxysilane, dimethyldi-t-butoxysilane, diethyldimethoxysilane, diethyldiethoxysilane, diethyldipropoxysilane, diethyldiisopropoxysilane, diethyldi-n-butoxysilane, diethyldi-i-butoxysilane, diethyldi-sec-butoxysilane, diethyldi-t-butoxysilane, dipropyldimethoxysilane, dipropyldiethoxysilane, dipropyldipropoxysilane, dipropyldiisopropoxysilane, dipropyldi-n-butoxysilane, dipropyldi-i-butoxysilane, dipropyldi-sec-butoxysilane, dipropyldi-t-butoxysilane, diisopropyldimethoxysilane, diisopropyldiethoxysilane, diisopropyldipropoxysilane, diisopropyldiisopropoxysilane, diisopropyldi-n-butoxysilane, diisopropyldi-i-butoxysilane, diisopropyldi-sec-butoxysilane, diisopropyldi-t-butoxysilane, diphenyldimethoxysilane, diphenyldiethoxysilane, diphenyldipropoxysilane, diphenyldiisopropoxysilane, diphenyldi-n-butoxysilane, diphenyldi-i-butoxysilane, diphenyldi-sec-butoxysilane, and diphenyldi-t-butoxysilane. Further, it is possible to use alkyltrialkoxysilane or dialkyldialkoxysilane which has alkyl group having C4 to C18 carbon atoms. It is also possible to use metal alkoxides including, for example, monomers having vinyl group such as vinyltrimethoxysilane and vinyltriethoxysilane; monomers having epoxy group such as 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, and 3-glycidoxypropyltriethoxysilane; monomers having styryl group such as p-styryltrimethoxysilane; monomers having methacrylic group such as 3-methacryloxypropylmethyldimethoxysilane, 3-methacryloxypropyltrimethoxysilane, 3-methacryloxypropylmethyldiethoxysilane, and 3-methacryloxypropyltriethoxysilane; monomers having acrylic group such as 3-acryloxypropyltrimethoxysilane; monomers having amino group such as N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, and N-phenyl-3-aminopropyltrimethoxysilane; monomer having ureide group such as 3-ureidepropyltriethoxysilane; monomers having mercapto group such as 3-mercaptopropylmethyldimethoxysilane and 3-mercaptopropyltrimethoxysilane; monomers having sulfide group such as bis(triethoxysilylpropyl) tetrasulfide; monomers having isocyanate group such as 3-isocyanatopropyltriethoxysilane; polymers obtained by polymerizing the foregoing monomers in small amounts; and composite materials characterized in that functional group and/or polymer is/are introduced into a part of the material as described above. Further, a part of or all of the alkyl group and the phenyl group of these compounds may be substituted with fluorine. Further, examples of the silica precursor include metal acetylacetonate, metal carboxylate, oxychloride, chloride, and mixtures thereof. The silica precursor, however, is not limited to the above examples. In addition to Si, examples of the metal species include Ti, Sn, Al, Zn, Zr, In, and mixtures thereof, but are not limited to these. It is also possible to use any appropriate mixture of precursors of the oxides of the above metals. Further, it is possible to use, as the silica precursor, a silane coupling agent having, in its molecule, a hydrolysis group having the affinity and the reactivity with silica and an organic functional group having the water-repellence. For example, the silane coupling agent is exemplified by silane monomer such as n-octyltriethoxysilane, methyltriethoxysilane, and methyltrimethoxysilane; vinylsilane such as vinyltriethoxysilane, vinyltrimethoxysilane, vinyltris(2-methoxyethoxy)silane, and vinylmethyldimethoxysilane; methacrylsilane such as 3-methacryloxypropyltriethoxysilane and 3-methacryloxypropyltrimethoxysilane; epoxysilane such as 2-(3,4-epoxycyclohexyl)ethyltrimethoxysilane, 3-glycidoxypropyltrimethoxysilane, and 3-glycidoxypropyltriethoxysilane; mercaptosilane such as 3-mercaptopropyltrimethoxysilane and 3-mercaptopropyltriethoxysilane; sulfursilane such as 3-octanoylthio-1-propyltriethoxysilane; aminosilane such as 3-aminopropyltriethoxysilane, 3-aminopropyltrimethoxysilane, N-(2-aminoethyl)-3-aminopropyltrimethoxysilane, N-(2-aminoethyl)-3-aminopropylmethyldimethoxysilane, and 3-(N-phenyl)-aminopropyltrimethoxysilane; and polymers obtained by polymerizing the monomers as described above.

When a mixture of TEOS and MTES is used as the precursor of the inorganic material, the mixture ratio thereof can be, for example, 1:1 in a molar ratio. The precursor produces amorphous silica by being subjected to hydrolysis and polycondensation reaction. An acid such as hydrochloric acid or an alkali such as ammonia is added in order to adjust the pH of the solution as a synthesis condition. The pH is preferably not more than 4 or not less than 10. Water may be added to perform the hydrolysis. The amount of water to be added can be not less than 1.5 times, with respect to the amount of metal alkoxide species, in the molar ratio.

Examples of a solvent of the precursor solution used in the sol-gel method include alcohols such as methanol, ethanol, isopropyl alcohol (IPA), and butanol; aliphatic hydrocarbons such as hexane, heptane, octane, decane, and cyclohexane; aromatic hydrocarbons such as benzene, toluene, xylene, and mesitylene; ethers such as diethyl ether, tetrahydrofuran, and dioxane; ketones such as acetone, methyl ethyl ketone, isophorone, and cyclohexanone; ether alcohols such as butoxyethyl ether, hexyloxyethyl alcohol, methoxy-2-propanol, and benzyloxyethanol; glycols such as ethylene glycol and propylene glycol; glycol ethers such as ethylene glycol dimethyl ether, diethylene glycol dimethyl ether, and propylene glycol monomethyl ether acetate; esters such as ethyl acetate, ethyl lactate, and γ-butyrolactone; phenols such as phenol and chlorophenol; amides such as N,N-dimethylformamide, N,N-dimethylacetamide, and N-methylpyrrolidone; halogen-containing solvents such as chloroform, methylene chloride, tetrachloroethane, monochlorobenzene, and dichlorobenzene; hetero-element containing compounds such as carbon disulfide; water; and mixture solvents thereof. Especially, ethanol and isopropyl alcohol are preferable. Further, a mixture of water and ethanol and a mixture of water and isopropyl alcohol are also preferable.

As an additive of the precursor solution used in the sol-gel method, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, dioxane, and the like, as a solution stabilizer. Further, as an additive of the precursor solution, it is possible to use a material which can generate an acid or alkali by being irradiated with light such as energy rays represented by ultraviolet rays such as excimer UV light. By adding such a material, the precursor solution can be gelled (cured) by being irradiated with light, thereby making it possible to form the inorganic material.

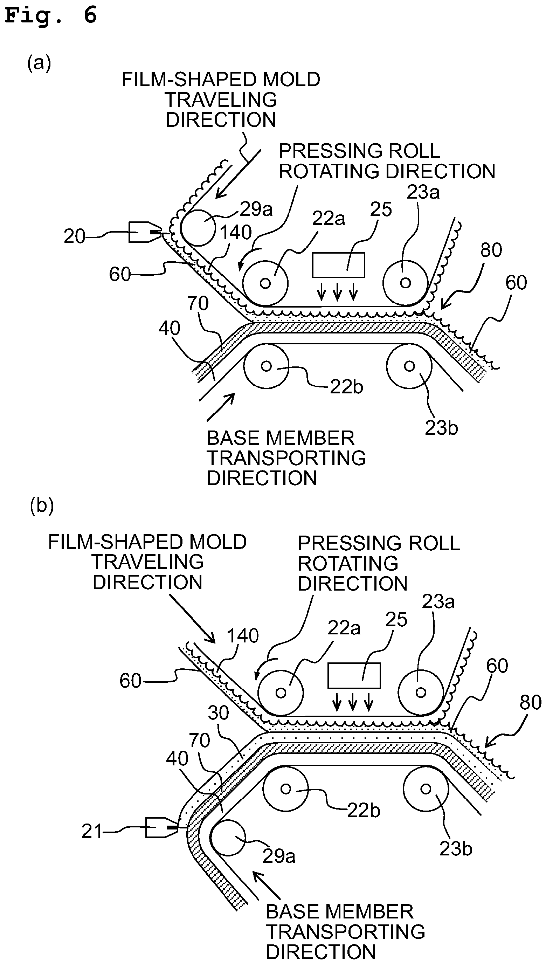

As depicted in Fig. 5(a), the concave-convex pattern of the mold 140 is coated with the precursor solution of the inorganic material (the solution of the inorganic material precursor) prepared as described above to form the first film (precursor film) 60. The mold for the concave-convex pattern transfer described above can be used as the mold 140, and a flexible film-shaped mold is preferably used as the mold 140. For example, as depicted in Fig. 6(a), the first film 60 can be formed on the film-shaped mold 140 by providing a back roll 29a over which the film-shaped mold 140 passes and a die coater 20 disposed to face the back roll 29a with the film-shaped mold 140 sandwiched therebetween, feeding or sending the film-shaped mold 140 to the vicinity of the tip of the die coater 20, and discharging the precursor solution from the die coater 20. From a viewpoint of mass-production, the film-shaped mold 140 is preferably coated with the precursor solution continuously by the die coater 20 provided at a predetermined position while the film-shaped mold 140 is continuously transported. Any coating method, such as the bar coating method, spray coating method, die coating method, or ink-jet method, can be used as the coating method of the film-shaped mold 140. Among them, the die coating method is preferably used because a mold having a relatively large width can be coated uniformly with the precursor solution and the coating can be quickly completed prior to curing of the coated precursor solution (prior to change into the inorganic material).

As depicted in Fig. 6(a), the film-shaped mold 140 with the first film 60 may be directly transported between pressing rolls 22a, 22b for a joining step as described later. Or, before the joining step, the precursor of the inorganic material forming the first film 60 may be changed into the inorganic material to cure or harden the first film 60. In particular, when the first film 60 is made from a material that causes degassing (generates gas) in curing, the first film 60 is preferably cured before the joining step for the following reasons. Namely, before the joining step, a surface, of the first film 60, on the side opposite to the surface contacting with the mold 140 is exposed to the atmosphere (or the surrounding environment), and thus gas generated during curing of the first film 60 is released to the surrounding, not causing any pattern defect by bubbles in the first film 60. During the joining step, however, the first film 60 is sandwiched between the second film 70 and the mold 140 (see Fig. 5(c)). Thus, gas (bubbles) generated from the first film 60 may remain between the second film 70 and the mold 140, which may cause a defect by bubbles in a concave-convex pattern to be formed in the first film 60. In order to cure the first film 60, the first film 60 is preferably heated in the atmosphere at temperatures ranging from room temperature to 300°C. When a material that generates an acid or alkali by being irradiated with light such as ultraviolet rays is added to the precursor solution, it is possible to cure the first film 60 by irradiating the first film 60 with energy rays represented by ultraviolet rays including, for example, excimer UV light to change the precursor into the inorganic material. When the first film 60 is cured before the joining step as described above, the film-shaped mold 140 with the first film 60 may be directly transported between the pressing rolls 22a, 22b for the joining step, or may be wound around a roll. When the film-shaped mold 140 is wound around the roll, it is advantageous to feed or unwound the film-shaped mold 140 directly from the roll in the joining step.

In order to improve the adhesion property between the first film 60 and the second film 70 (or between the first film 60 and the adhesive layer 30 as described later), a surface modified layer may be provided on the cured first film 60. Examples of materials of the surface modified layer include silane monomer such as n-octyltriethoxysilane, methyltriethoxysilane, and methyltrimethoxysilane; vinylsilane such as vinyltriethoxysilane, vinyltrimethoxysilane, vinyltris(2-methoxyethoxy)silane, and vinylmethyldimethoxysilane; methacrylsilane such as 3-methacryloxypropyltriethoxysilane and 3-methacryloxypropyltrimethoxysilane; epoxysilane such as 2-(3,4-epoxycyclohexyl) ethyltrimethoxysilane, 3-glycidoxypropyltrimethoxysilane, and 3-glycidoxypropyltriethoxysilane; mercaptosilane such as 3-mercaptopropyltrimethoxysilane and 3-mercaptopropyltriethoxysilane; sulfursilane such as 3-octanoylthio-1-propyltriethoxysilane; aminosilane such as 3-aminopropyltriethoxysilane, 3-aminopropyltrimethoxysilane, N-(2-aminoethyl)-3-aminopropyltrimethoxysilane, N-(2-aminoethyl)-3-aminopropylmethyldimethoxysilane, and 3-(N-phenyl)-aminopropyltrimethoxysilane; and polymers obtained by polymerizing the monomers as described above. A titanium coupling agent may be used instead of the above silane coupling agents. Alternatively, a surface modified layer may be provided in such a manner that the surface of the first film 60 (the surface on the side opposite to the surface contacting with the mold 140) is subjected to treatment with an energy ray, such as plasma treatment, corona treatment, excimer irradiation treatment, or UV/O₃ treatment.

The first film 60 may be formed by a dry process instead of the above-described wet process. For example, the first film 60 can be formed by depositing the inorganic material, such as the inorganic oxide, inorganic nitride, inorganic oxynitride, inorganic sulfide, or inorganic carbide on the concave-convex pattern of the mold 140 using a well-known dry process, such as a physical vapor deposition method (PVD) including evaporation, sputtering, and the like; or a chemical vapor deposition method (CVD).

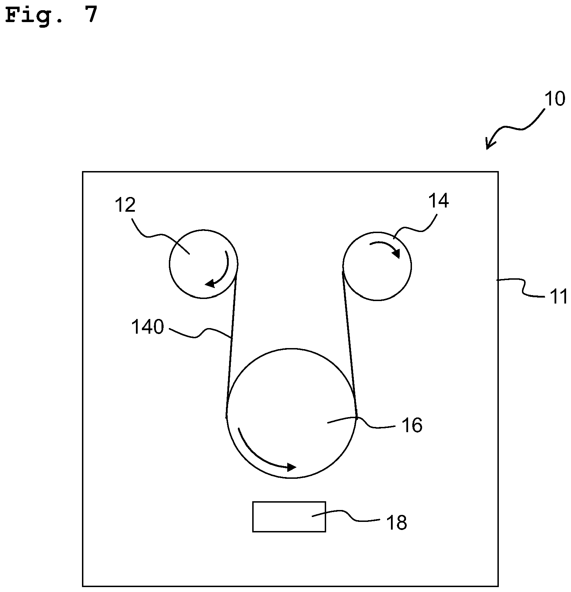

For example, when a film of metal oxide is formed as the first film on the concave-convex pattern of the film-shaped mold by sputtering, it is possible to use a sputtering apparatus 10 conceptually depicted in Fig. 7. The sputtering apparatus 10 includes a vacuum chamber 11. The vacuum chamber 11 may be formed in any shape which keeps the inside of the vacuum chamber 11 in a reduced pressure state. The vacuum chamber 11 typically has a rectangular parallelepiped shape, cylindrical shape, or the like. In the vacuum chamber 11, there are provided a feeding roll 12 that feeds the film-shaped mold 140, a winding roll 14 that winds or rolls up the film-shaped mold 140 thereon, and a coating roll 16 disposed on a transporting route of the film-shaped mold 140 from the feeding roll 12 to the winding roll 14. Further, the vacuum chamber 11 may include a guide roll (not depicted) that transports the film-shaped mold 140. A sputtering target 18 is disposed to face the film-shaped mold 140 passing over the coating roll 16. The sputtering target 18 may be metal or metal oxide. It is only required that the size of the sputtering target 18 in a width direction (the direction perpendicular to Fig. 7) be larger than the width of the film-shaped mold 140.

When the first film is formed by using the sputtering apparatus 10, pressure in the vacuum chamber 11 is reduced to high vacuum at first. Then, metal atoms (and oxygen atoms) are sputtered from the sputtering target by DC plasma or high-frequency plasma while noble gas, such as Ar, and oxygen gas are being introduced into the vacuum chamber 11. Meanwhile, the film-shaped mold 140 is fed from the feeding fool 12 and transported to the coating roll 16. The metal atoms sputtered from the sputtering target 18 react with oxygen on the surface of the film-mold 140 to cause the deposition of metal oxide, while the film-shaped mold 140 is passing over the coating roll 16 in a state of being brought into contact with a surface of the coating roll 16. Next, the film-shaped mold 140 on which metal oxide is deposited is wound around the winding roll 14. The film-shaped mold 140 may pass through the guide roll or the like on the way, as appropriate.

When a metal oxide film is formed as the first film on the concave-convex pattern of the film-shaped mold by an electron beam heating evaporation method, it is possible to use, for example, an electron beam heating evaporation apparatus configured as follows. Namely, in a vacuum chamber that is formed similarly to the sputtering apparatus 10 to include the feeding roll that feeds the film-shaped mold, the winding roll that winds or rolls up the film-shaped mold thereon, and the coating roll disposed on the transporting route of the film-shaped mold 140 from the feeding roll 12 to the winding roll 14, there are provided a crucible that contains metal or metal oxide and is disposed to face the film-shaped mold passing over the coating roll and an electron gun that irradiates the interior of the crucible with an electron beam to evaporate metal or metal oxide. In that configuration, the metal or metal oxide in the crucible may be heated and evaporated by the electron beam while the film-shaped mold is being transported, so that metal oxide will be deposited on the film-shaped mold passing over the coating roll. In that situation, it is allowable to or not to introduce oxygen gas into the chamber depending on the degree of oxidation of the material contained in the crucible and a targeted degree of oxidation of the first film.

When a metal oxide film is formed as the first film on the concave-convex pattern of the film-shaped mold by atmospheric-pressure plasma CVD, it is possible to use methods described, for example, in Japanese Patent Application Laid-open Nos. 2004-052028 and 2004-198902. An organometallic compound may be used as a raw material compound, and the raw material compound may be in either a gaseous, liquid, or solid state at normal temperature under normal pressure. When the raw material compound is used in its gaseous state, the raw material compound can be introduced as it is into a discharge space; on the other hand, when the raw material compound is in a liquid or solid state, the material is used after being gasified once by means of heating, bubbling, decompression, ultrasonic radiation, etc. In view of such a situation, preferred organometallic compounds include, for example, a metal alkoxide of which boiling point is not more than 200°C.

Examples of such metal alkoxide include a silicon compound such as silane, tetramethoxysilane, tetraethoxysilane (TEOS), tetra-n-propoxysilane, etc.; a titanium compound such as titanium methoxide, titanium ethoxide, titanium isopropoxide, titanium tetraisopropoxide, etc.; a zirconium compound such as zirconium-n-propoxide, etc.,; an aluminum compound such as aluminum ethoxide, aluminum triisopropoxide, aluminum isopropoxide, etc.; antymony ethoxide; arsenic triethoxide; zinc acetylacetonate; diethylzinc; and the like.

Further, cracking gas is used together with the gaseous raw material containing these organometallic compounds to compose a reactive gas, for the purpose of cracking the organometallic compounds to thereby obtain an inorganic compound. The cracking gas is exemplified, for example, by hydrogen gas, methane gas, acetylene gas, carbon monoxide gas, carbon dioxide gas, nitrogen gas, ammonia gas, nitrous oxide gas, nitrogen oxide gas, nitrogen dioxide gas, oxygen gas, water vapor, fluorine gas, hydrogen fluoride, trifluoro alcohol, trifluorotoluene, hydrogen sulfide, sulfur dioxide, carbon bisulfide, and chlorine gas. For example, metal oxide can be formed by using oxygen gas, metal nitride can be formed by using ammonia gas, and metal oxynitride can be formed by using ammonia gas and nitrous oxide gas.

In the plasma CVD method, a discharge gas easily turned to a plasma state is mainly mixed with the reactive gas. As the discharge gas, it is possible to use a nitrogen gas; a rare gas such as a gas of an element of the eighteenth group of the periodic table, specifically, helium, neon, argon, etc.; and the like. In particular, the nitrogen gas is preferably used in view of the production cost.

The film formation is performed by mixing the discharge gas with the reactive gas to thereby obtain a mixed gas, and by supplying the mixed gas to a discharge plasma generating apparatus (plasma generator). The ratio of the discharge gas relative to the reactive gas is different depending on the property of a film as an object to be formed, and the percentage of the discharge gas in the entire mixed gas is not less than 50%.

For example, silicon alkoxide (such as tetraethoxysilane (TEOS)), which is one of the metal alkoxides having boiling point of not more than 200°C, is used as the raw material compounds, oxygen is used as the cracking gas, and the rare gas or an inert gas such as nitrogen is used as the discharge gas, and the plasma discharge is performed. Thus, it is possible to form a film of silicon oxide as the first film.

In the CVD method as described above, it is possible to deposit any one of metal carbide, metal nitride, metal oxide, metal sulfide, metal halide, or mixtures thereof (e.g., metal oxynitride, metal oxide halide, and metal nitride carbide) by selecting conditions such as the metal compound as the raw material, cracking gas, decomposition temperature, and power to be inputted or supplied. Thus, the film is preferably obtained by CVD method.

In order to improve the adhesion property between the first film formed by the dry process as described above and the second film (or the adhesive layer) which will be described later, a surface modified layer may be provided on the first film. The surface modified layer can be formed by using any of those listed as the materials and methods that may be used for the case in which the surface modified layer is provided on the first film formed by the wet process.

### <Second film formation step>

Subsequently, as depicted in Fig. 5(b), the second film 70 is formed, as the second gas barrier layer, on the base member 40 (step S2 of Fig. 4). A film-shaped base member may be used as the base member 40. The second film 70 may be formed by any of the wet process and the dry process which have been explained as the formation method of the first film 60. As depicted in Fig. 6(a), when the first film 60 is formed by the wet process and the joining step is performed by transporting the first film in an uncured state between the pressing rolls 22a, 22b, the second film 70 formed by the wet process is cured before the joining step, or the second film 70 is formed by the dry process. When the first film 60 formed by the wet process is cured before the joining step, or when the first film 60 is formed by the dry process, the second film 70 is formed by the wet process and the second film in an uncured state is subjected to the joining step.

When the second film 70 formed by the wet process is cured, or when the second film 70 is formed by the dry process, a surface modified layer may be provided on the second film 70 to improve the adhesion property between the first film 60 (or the adhesive layer as described later) and the second film 70. The surface modified layer can be formed by using any of those listed as the materials and methods that may be used for the case in which the surface modified layer is provided on the first film 60. When the second film 70 formed by the wet process is cured, or when the second film 70 is formed by the dry process, the film-shaped base member 40 with the second film 70 may be directly transported between the pressing rolls 22a, 22b to perform the joining step, or it may be wound around a roll. When the film-shaped base member 40 is wound around the roll, it is advantageous to feed or unwound the film-shaped base member directly from the roll during the joining step.

The first film formation step may be performed before the second film formation step, the second film formation step may be performed before the first film formation step, or the first film formation step and the second film formation step may be performed at the same time.

### <Joining step>

Subsequently, as depicted in Fig. 5(c), the mold 140 and the base member 40 are overlapped with each other, so as to join or bond the first film 60 and the second film 70 (step S3 of Fig. 4). For example, as depicted in Fig. 6(a), sending the film-shaped mold 140 with the first film 60 and the film-shaped base member 40 with the second film 70 between the pressing rolls 22a, 22b allows the mold 140 and the base member 40 to overlap with each other and allows the first film 60 and the second film 70 to adhere to (be brought into tight contact with) each other. Then, the first film 60 or the second film 70 is cured. For example, the first film 60 or the second film 70 can be cured by being heated or irradiated with an energy ray, such as ultraviolet ray, by use of an UV lamp 25 or the like as depicted in Fig. 6(a). Accordingly, the first film 60 and the second film 70 are fixed to each other in the state of being joined between the film-shaped base member 40 and the film-shaped mold 140.

Such a roll process using the pressing rolls 22a and 22b has the following advantages over the pressing system. For example, it is possible to reduce joining pressure and releasing force (peeling force) owing to the line contact between the first film 60 on the film-shaped mold 140 and the second film 70 on the film-shaped base member 40, thereby making it possible to easily manufacture a gas barrier member with larger area; and it is possible to press the film-shaped mold 140 against the entire surface of the film-shaped base member 40 uniformly, thereby bringing the first film 60 into tight contact with the second film 70 uniformly and preventing any adhesion failure.

Those preferably used as the pressing rolls 22a and 22b include, for example, a roll having a heat-resistant coating film provided on a roll surface and made from a resin material, such as ethylene-propylene-diene rubber (EPDM), silicone rubber, nitrile rubber, fluoro rubber, acrylic rubber, or chloroprene rubber.

### <Releasing step>

After the first film 60 and the second film 70 are joined to each other, as depicted in Fig. 5(d), the mold 140 is released from the first film 60 (step S4 of Fig. 4). Any publicly known releasing method can be adopted as the mold releasing method. In a case of using the mold with concave-convex pattern in which each of convexities and concavities has an elongated shape and a waveform structure in which inclination is gentle, there is an advantage that releasing property (releasablity or peeling property) is satisfactory. Further, since the first film 60 is firmly joined to the second film 70 by curing the first film 60 or the second film 70 in the joining step, there is no possibility that any portions of the first film 60 is released from the base member 40 in a state of adhering to the mold 140. In the roll process, releasing force may be smaller than that in the pressing system, and the mold 140 can be easily released from the first film 60 without allowing the first film 60 to remain on the mold 140. Further, a releasing roll may be used to improve the mold releasability. As depicted in Fig. 6(a), releasing rolls (peeing rolls) 23a, 23b are disposed downstream of the pressing rolls 22a, 22b. The releasing roll 23a rotates and supports the film-shaped mold 140 with the first film 60 while urging the film-shaped mold 140 with the first film 60 against the film-shaped base member 40 with the second film 70, and the releasing roll 23b rotates and supports the film-shaped base member 40 with the second film 70 while urging the film-shaped base member 40 with the second film 70 against the film-shaped mold 140 with the first film 60. With this configuration, it is possible to maintain a state in which the first film 60 adheres to the second film 70 as long as a distance between the pressing rolls 22a, 22b and the releasing rolls 23a, 23b (for a certain period of time). Then, a path of the film-shaped mold 140 is changed so that the film-shaped mold 140 is pulled up above the releasing roll 23a on the downstream side of the releasing roll 23a and a path of the film-shaped base member 40 is changed so that the film-shaped base member 40 is pulled down below the releasing roll 23b on the downstream side of the releasing roll 23b, thereby releasing (peeling off) the film-shaped mold 140 from the first film 60. The first film 60 from which the mold 140 is released is formed with the concave-convex pattern 80 that has been transferred from (is corresponding to) the concave-convex pattern formed on the surface of the mold 140.

In order to prevent such a situation that the mold 140 is released from the first film 60 in a state where the first film 60 partially adheres to the mold 140, the adhesive force between the first film 60 and the mold 140 is preferably not more than 200 N/m, more preferably not more than 100 N/m. The adhesive force between the first film 60 and the mold 140 can be measured as follows. A supporting substrate is coated with the material for the first film 60 to form a coating film, and the supporting substrate is overlapped with the mold such that the coating film is brought into tight contact with (adheres to) the concave-convex pattern surface of the mold. Then, the coating film is cured. Accordingly, a sample having a structure formed by the supporting substrate/the first film/the mold is obtained. This sample is cut into strips of 30 mm width, and the mold is released from the first film by pulling an end of the mold upward at a constant speed in a normal direction of the supporting substrate by use of a tensile tester (STROGRAPH E-H produced by Toyo Seiki Seisaku-sho, Ltd.). The tensile strength of the mold represents the adhesive force between the first film and the mold.

As described above, it is possible to manufacture the gas barrier member 100, as depicted in Figs. 1(a) and 5(d), in which the second film 70 and the first film 60 are formed on the base member 40 in that order.

A covering layer (coating layer) may be formed on the surface of the first film 60 of the gas barrier member 100. The thickness of the covering layer is preferably in a range of 25% to 150% of the standard deviation of depth of concavities and convexities of the concave-convex pattern 80 formed in the first film 60. Such a covering layer can cover any foreign matter and/or defect which might be present on the concave-convex pattern. Thus, when a light emitting element such as an organic EL element is formed by using the gas barrier member, it is possible to effectively prevent any leak current in the light emitting element. Further, a light emitting element, which is formed by using the gas barrier member provided with the covering layer having a thickness within the above range, has good light extraction efficiency.

The covering layer can be formed through the above-described wet process by using any of the materials usable as the material for the first film. It is especially preferable that the covering layer be formed by using a material that is same as the material used as the material for the first film. Forming the covering layer and the first film by use of the same material can prevent light reflection at an interface between the covering layer and the first film.

Further, a hydrophobization treatment may be performed on the surface of the first film (the surface of the covering layer when the covering layer is formed). Any known method for the hydrophobization treatment may be used. For example, regarding the surface of silica, the hydrophobization treatment can be performed with dimethyl dichlorosilane, trimethyl alkoxysilan, etc., or with a silicone oil and a trimethylsilylating agent such as hexamethyl-disilazane. Alternatively, it is also allowable to employ a surface treatment method for a surface of metal oxide powder with supercritical carbon dioxide. Allowing the surface of the first film to have hydrophobicity makes it possible to easily remove moisture from the gas barrier member during a manufacturing process of a light emitting element, such an organic EL element, in which the gas barrier member manufactured through the manufacturing method of the first embodiment is used. This makes it possible to prevent, in the light emitting element, any generation of defect, such as a dark spot, and any deterioration of the device.

Further, a protective layer may be formed on the surface of the first film (the surface of the covering layer when the covering layer is formed). Examples of resins that may be used for forming the protective layer include solvent-based resins and water-based resins which are exemplified, for example, by polyester-based resin, urethane-based resin, acrylic-based resin, polyvinyl alcohol-based resin, ethylene-unsaturated carboxylate copolymer resin, ethylene-vinyl alcohol-based resin, vinyl-modified resin, nitrocellulose-based resin, silicone-based resin, isocyanate-based resin, epoxy-based resin, oxazoline group-containing resin, modified styrenic-based resin, modified silicone-based resin, and alkyl titanate. Only one kind of the resin as described above may be used singly, or two or more kinds of the resins may be used in combination. In order to improve the barrier property, wear property, and sliding property, a layer that is obtained by mixing one or more kinds of inorganic particles selected among silica sol, alumina sol, particulate inorganic filler, and layered inorganic filler with one or more of the above-listed resins or a layer that is made from inorganic particle-containing resin formed by polymerizing the raw material of any of the above-listed resins in presence of any of the above-listed inorganic particles, is preferably used as the protective layer.

In addition to the covering layer and the protective layer, various functional layers may be provided on the surface of the first film. Examples of the functional layers include optical functional layers such as an antireflection layer, a polarization layer, a color filter, and an ultraviolet-ray absorption layer; mechanical functional layers such as a hard coating layer and a stress-relaxation layer; electric functional layers such as an antistatic layer and a conductive layer; an antifogging layer; an antifouling layer; and a layer to be printed.

Although the above embodiment describes the method for manufacturing the gas barrier member by using the film-shaped mold, the gas barrier member can be manufactured by using a hard mold, such as a metal mold or a quartz mold, in a manner similar to the above-described manufacturing method. When the hard mold is used, a flexible base member, such as a film-shaped base member, is preferably used as the base member. In the joining step of the above embodiment, the pressing rolls are pressed against the back surface of the film-shaped mold and the back surface of the film-shaped base member. When the hard mold and the film-shaped base member are used, the pressing roll may be pressed against a back surface (an opposite surface of the surface with the second film) of the film-shaped base member in the joining step. This allows the hard mold to be pressed against the entire surface of the film-shaped base member uniformly. In the releasing step of the above embodiment, the film-shaped mold is released from the first film, the film-shaped base member and the second film by urging the releasing rolls from the sides of the back surfaces of the film-shaped mold and the film-shaped base member toward each other and changing paths of the film-shaped mold and the film-shaped base member at the downstream of the releasing rolls. When the hard mold and the film-shaped base member are used, the film-shaped base member, the second film and the first film are preferably released from the hard mold by urging the releasing roll from the back surface of the film-shaped base member toward the hard mold and changing the route (path) of the film-shaped base member at the downstream of the releasing roll. With this configuration, small releasing force easily releases the mold 140 from the first film 60 without residue of any portions of the first film on the mold.

Although the above embodiment describes the method for manufacturing the gas barrier member by using the film-shaped base member, the gas barrier member can be manufactured by using a hard base member, such as a glass substrate, in a manner similar to the above-described manufacturing method. When the hard base member is used, a flexible mold, such as a film-shaped mold, is preferably used as the mold. In the joining step of the above embodiment, the pressing rolls are pressed against the back surface of the film-shaped mold and the back surface of the film-shaped base member. When the hard base member and the film-shaped mold are used, the pressing roll may be pressed against a back surface (an opposite surface of the surface with the concave-convex pattern) of the film-shaped mold in the joining step. This allows the film-shaped mold to be pressed against the entire surface of the hard base member uniformly. In the releasing step of the above embodiment, the film-shaped mold is released from the first film, the film-shaped base member, and the second film by urging the releasing rolls from the sides of the back surfaces of the film-shaped mold and the film-shaped base member toward each other and changing paths of the film-shaped mold and the film-shaped base member at the downstream of the releasing rolls. When the hard base member and the film-shaped mold are used, the film-shaped mold is preferably released from the hard base member, the second film, and the first film by urging the releasing roll from the back surface of the film-shaped mold toward the hard base member and changing the path of the film-shaped mold at the downstream of the releasing roll. With this configuration, small releasing force easily releases the mold 140 from the first film 60 without residue of any portions of the first film on the mold.

The member having films formed on the base member is typically manufactured by sequentially stacking or depositing the films on the base member. In that case, a film to be stacked first needs to be a film that is not damaged by stacking of a subsequent film, and each subsequent film needs to be stacked by a method not damaging the film to be stacked first. Thus, film materials and staking methods (coating methods or depositing methods) therefor are limited, which makes it impossible, in some cases, to form a film with a desired function by using a desired material. Meanwhile, in the method for manufacturing the gas barrier member according to the present embodiment, the first film is formed on the concave-convex pattern of the mold and the second film is formed on the base member, and then the first film and the second film are joined in an overlapped manner, as described above. Thus, stacking of the first film does not damage the second film, and staking of the second film does not damage the first film. Accordingly, the method for manufacturing the gas barrier member according to the present embodiment has such an advantage that composing materials and coating or depositing methods for the first film and the second film are not restricted and the first film and the second film can be formed by desired materials and desired methods.

In a general nanoimprint method, when a member with a concave-convex pattern is manufactured by using a mold with a concave-convex pattern, a base member is coated with a transfer material having relatively high fluidity through the wet process, and the transfer material is cured while being pressed against the concave-convex pattern surface of the mold. In this method, the transfer material is limited to those which can be applied on the base member by coating and is not be degassed in curing, and thus a film with a desired function can not be formed by using a desired material in some cases. Meanwhile, in the method for manufacturing the gas barrier member of the present embodiment, the first film formed on the concave-convex pattern of the mold is joined onto the base member as described above and then the mold is released from the first film, thereby forming the first film to which the concave-convex pattern of the mold has been transferred. Namely, the member with the concave-convex pattern is manufactured by applying or depositing the transfer material on the concave-convex pattern and allowing the transfer material to adhere to the base member side. Thus, it is possible to use, as the transfer material, materials that can be applied by a method rather than the coating, such as a dry process, and materials that are degassed in curing.

As described above, the manufacturing method of the present embodiment has a wide choice of composing materials and film-forming methods for the first film and the second film, thus making it possible to manufacture a functional member with a good function, such as a gas barrier member with a good gas barrier property. The gas barrier member manufactured by the manufacturing method of the present embodiment is suitably used for organic EL elements, liquid crystal displays, solar cells, and the like those of which need a high gas barrier property. Further, the gas barrier member manufactured by the manufacturing method of the present embodiment is suitably used for packaging applications, such as packaging of goods and packaging for preventing any deterioration of foods, industrial goods, medical products, and the like. When the gas barrier member manufactured by the manufacturing method of the present embodiment is used for packaging applications, there is an advantage that an irregular minute concave-convex pattern, as depicted in Figs. 2(a) and 2(b), formed on the surface of the gas barrier member can prevent haze and glare in appearance, as well as an advantage that a packaged product can be protected with a high gas barrier property. When the member manufactured by the manufacturing method of the present embodiment is a film-shaped member, the concave-convex pattern formed on the surface prevents blocking (sticking of the member) which would be otherwise caused when the member is stored in an overlapped manner or in a roll-shape. Thus, the member manufactured by the manufacturing method of the present embodiment also has the advantage of easy storage.

The manufacturing method of the present embodiment can form the concave-convex pattern without photolithography that causes a large amount of waste liquid, and thus the manufacturing method of the present embodiment is environmentally friendly. Further, the manufacturing method of the present embodiment can continuously produce the gas barrier member at high speed by using the roll process, and thus the manufacturing method of the present embodiment has high production efficiency. When the first film or the second film is cured before the joining step, the film-shaped mold with the cured first film or the base member with the cured second film can be stored by being wound into a roll. Thus, production adjustment is easily made, thereby making it possible to produce the member with the concave-convex pattern efficiently.

### [First modified embodiment of method for manufacturing gas barrier member]

An explanation will be made about a first modified embodiment of the method for manufacturing the gas barrier member. The first modified embodiment of the method for manufacturing the gas barrier member mainly includes: a step of forming the first film on the concave-convex pattern of the mold; a step of forming the second film on the base member; a step of forming the adhesive layer on the first film formed on the mold or the second film formed on the base member; a step of joining the first film and the second film via the adhesive layer; and a step of releasing the mold from the first film. In the first embodiment, the first film or the second film is cured in the joining step to fix the first film and the second film in a state that the first and second films are joined each other. In the first modified embodiment, the first film and the second film are joined and fixed via the adhesive layer.

### <First film formation step>

The first film is formed, as the first gas barrier layer, on the concave-convex pattern of the mold by a method similar to the first embodiment. In the first modified embodiment, the first film can be formed similarly to the first embodiment by the wet process or the dry process. When the first film is formed by the wet process, the first film is cured before an adhesive layer formation step which will be described later.

### <Second film formation step>

The second film is formed, as the second gas barrier layer, on the base member by a method similar to the first embodiment. In the first modified embodiment, the second film can be formed similarly to the first embodiment by the wet process or the dry process. When the second film is formed by the wet process, the second film is cured before the adhesive layer formation step.

### <Adhesive layer formation step>

Subsequently, the adhesive layer is formed by applying adhesive on the first film formed on the mold or the second film formed on the base member. For example, as depicted in Fig. 6(b), the adhesive layer 30 is formed on the second film 70 by feeding or sending the base member 40 with the second film 70 to the vicinity of the tip of a die coater 21 and discharging adhesive from the die coater 21. From a viewpoint of mass-production, adhesive is preferably applied on the second film 70 continuously by the die coater 21 provided at a predetermined position while the base member 40 is continuously transported. Any coating method, such as the bar coating method, spin coating method, spray coating method, dip coating method, die coating method, or ink-jet method, can be used as the adhesive applying method. Among them, the bar coating method, die coating method, and spin coating methods are preferably used because a base member having a relatively large area can be coated uniformly with adhesive and the coating can be quickly completed prior to curing of adhesive.

When the adhesive is applied on the second film, the first film formation step may be performed after the adhesive layer formation step. When the adhesive is applied on the first film, the second film formation step may be performed after the adhesive layer formation step.

### <Joining step>

Subsequently, the base member and the mold are overlapped with each other in a state where the first film and the second film are joined to each other via the adhesive layer. For example, as depicted in Fig. 6(b), the first film 60 and the second film 70 can be brought into tight contact with each other via the adhesive layer 30 in a state where the base member 40 and the mold 140 are overlapped with each other by sending the film-shaped mold 140 with the first film 60 and the base member 40 with the second film 70 and the adhesive layer 30 between the pressing rolls 22a, 22b. Further, the adhesive layer 30 is cured after the first film 60 and the second film 70 are brought into tight contact with each other as described above. As depicted in Fig. 6(b), the adhesive layer 30 can be cured by being irradiated with an energy ray, such as ultraviolet ray, by use of the UV lamp 25 or the like. Accordingly, the first film 60 and the second film 70 are joined and fixed to each other via the adhesive layer 30 between the base member 40 and the film-shaped mold 140.

### <Releasing step>

The mold is released from the first film after the first film and the second film are joined via the adhesive layer. The mold can be released by a method similar to the first embodiment.

As described above, it is possible to manufacture the gas barrier member 100a, as depicted in Fig. 1(b), having the concave-convex pattern 80, in which the second film 70 and the first film 60 are formed on the base member 40 in that order, and the adhesive layer 30 is formed between the first film 60 and the second film 70.

### [Second modified embodiment of method for manufacturing gas barrier member]

A film different from the first film may be formed on the first film formed on the mold after the first film formation step of the first embodiment or the first modified embodiment. The film different from the first film may be a single layer film or a multilayer film. When the film different from the first film is formed, the first film and the film that is different from the first film and formed on the first film form the first gas barrier layer. The film different from the first film may be formed similarly to the first film by the dry process or the wet process, such as coating. A stress relaxation layer may be provided between respective layers.

A film different from the second film may be formed on the second film formed on the base member after the second film formation step of the first embodiment or the first modified embodiment. The film different from the second film may be a single layer film or a multilayer film. When the film different from the second film is formed, the second film and the film that is different from the second film and formed on the second film form the second gas barrier layer. The film different from the second film may be formed similarly to the second film by the dry process or the wet process, such as coating. A stress relaxation layer may be provided between respective layers.

In the joining step of the second modified embodiment, the first film and the second film are joined via the film different from the first film and/or the film different from the second film. In the present invention, the wording "the first film and the second film are joined" includes not only the case in which the first film and the second film are joined directly or via the adhesive layer but also the case in which the first film and the second film are joined via the film different from the first film and/or the film different from the second film.

### [Second gas barrier member]

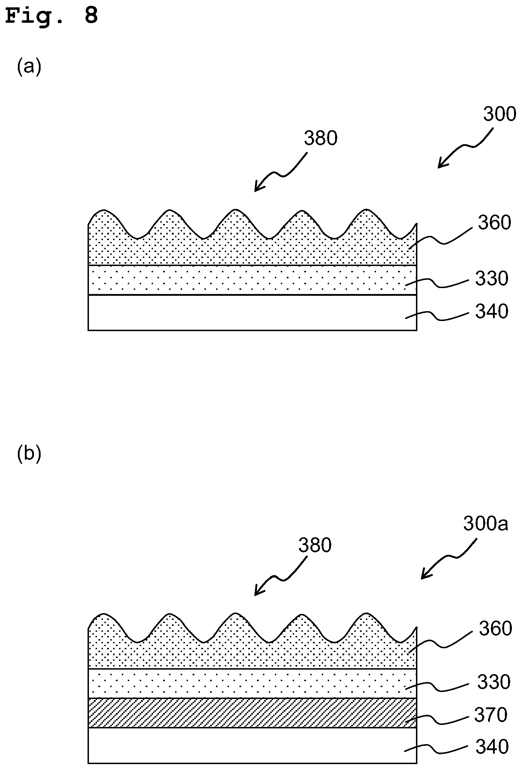

As depicted in Fig. 8(a), a gas barrier member 300 with a concave-convex structure (concave-convex pattern) 380, which is obtained by the second embodiment of the method for manufacturing the gas barrier member with the concave-convex pattern which will be described later, includes a first film 360 that is formed, as the first gas barrier layer, on a base member 340 via an adhesive layer 330. As depicted in Fig. 8(b), a gas barrier member 300a, which is obtained by the fourth modified embodiment of the method for manufacturing the gas barrier member with the concave-convex pattern which will be described later, further includes a second film 370 that is formed, as the second gas barrier layer, on the base member 340.

### <Base member>

As the base member 340, any of the substrates usable as the base member 40 of the first gas barrier member 100 may be used as appropriate.

### <First film>

The gas barrier member 300 includes the first film 360, as the first gas barrier layer, which prevents permeation of oxygen and water vapor. As the material forming the first film 360, it is preferable to use inorganic materials, such as metal oxide, metal nitride, metal oxynitride, metal sulfide, and metal carbide, and it is more preferable to use inorganic oxide, inorganic nitride, and inorganic oxynitride, such as silicon oxide, aluminum oxide, silicon nitride, silicon oxynitride, aluminum oxynitride, magnesium oxide, zinc oxide, indium oxide, tin oxide, titanic oxide, copper oxide, cerium oxide, and tantalum oxide.

The water vapor transmission rate of the first film 360 is preferably not more than 10⁻² g·m⁻²·day⁻¹ to allow the gas barrier member 300 to have a sufficient gas barrier property. Such a first film 360 is formed by the dry process such as a vapor evaporation method, sputtering method, or CVD method, as described later.

The first film 360 preferably has a light transmission property. The first film 360 preferably has a transmittance of not less than 80% at a measurement wavelength of 550 nm, more preferably has a transmittance of not less than 90% at the measurement wavelength of 550 nm.

The thickness of the first film 360 is preferably in a range of 5 nm to 2 µm. When the thickness is less than 5 nm, there are many cases of film defect, and any sufficient moisture-preventing effect (gas barrier effect) cannot be obtained. When the thickness exceeds 2 µm, the time required for film formation is increased to reduce production efficiency. In this context, the thickness of the first film 360 means an average value of distances from the bottom surface of the first film 360 to the surface in which the concave-convex pattern 380 is formed.

The surface of the first film 360 is formed to have the minute concave-concave pattern (concave-convex structure) 380. The minute concave-concave pattern 380 may be any pattern similar to the concave-convex pattern 80 of the first gas barrier member 100.

Although Fig. 8(a) depicts a structure in which the first gas barrier layer is formed by the first film 360 as a single layer, the first gas barrier layer may be formed by a multilayer film including the first film 360 and at least one film that is different from the first film 360 and disposed under the first film 360 (on a side, of the first film 360, facing the base member 340, namely, a position between the first film 360 and the adhesive layer 330). Each of the at least one film that is different from the first film 360 and disposed under the first film 360 may be a film made from any of the inorganic materials listed as the materials that may be used for the first film 360, or a film formed by the wet process, such as coating method. The film formed by the wet process includes silicon oxide, silicon nitride, and silicon oxynitride formed by applying, as a precursor, polysilazane, perhydropolysilazane (PHPS), organopolysilazane, silicon alkoxide-added polysilazane, glycidol-added polysilazane, alcohol-added polysilazane, metal carboxylate-added polysilazane, acetylacetonato complex-added polysilazane, and metallic fine particles-added polysilazane and then forming them into ceramic by oxidation; SiO₂, TiO₂, ZnO, ZnS, ZrO, Al₂O₃, BaTiO₃, SrTiO₂, ITO and the like formed by applying, as a precursor, metal alkoxide and then curing it; SiO₂, TiO₂, ZnO, ZnS, ZrO, Al₂O₃, BaTiO₃, SrTiO₂, and the like formed by applying a dispersion liquid of fine particles and then drying it; and the like. From the viewpoint of the gas barrier property, it is allowable to use, as the material for the at least one film that is different from the first film 360 and disposed under the first film 360, materials used for the sealing material of the organic EL element, such as XNR5516Z produced by NAGASE & CO., LTD.; TB3124 produced by THREEBOND HOLDINGS CO., LTD.; and CELVENUS H001 produced by Daicel Corporation. Further, it is allowable to use a material including an ultraviolet absorbent material in any of the above-listed materials. The ultraviolet absorbent material has the function or effect to prevent deterioration of the film by absorbing ultraviolet rays and converting the light energy into something harmless such as heat. Any publicly known agent may be used as the ultraviolet absorbent material. Those usable as the ultraviolet absorbent material include, for example, benzotriazole-based absorbents, triazine-based absorbents, salicylic acid derivative-based absorbents, benzophenone-based absorbents, etc. A stress relaxation layer may be provided between respective layers. As the stress relaxation layer, it is possible to use any of the materials listed as the materials for the stress relaxation layer of the first gas barrier member.

When the gas barrier member, of which first gas barrier layer is formed as the multilayer film, is used as an optical substrate of a light-emitting element, the first gas barrier layer preferably has a light transmission property. For example, the first gas barrier layer preferably has a transmittance of not less than 80% at a measurement wavelength of 550 nm, more preferably has a transmittance of not less than 90% at the measurement wavelength of 550 nm.

When the first gas barrier layer is formed as the multilayer film, the thickness of the first gas barrier layer is preferably in a range of 5 nm to 20 µm. When the thickness is less than 5 nm, there are many cases of film defect, and any sufficient moisture-preventing effect (gas barrier effect) cannot be obtained. When the thickness exceeds 20 µm, although the moisture-preventing effect is theoretically high, the internal stress is high, which in turn makes the first gas barrier layer to be brittle. This makes it impossible to obtain any desired moisture-preventing effect. Further, when the base member 340 is made from a flexible material, there is such a fear that any damage including cracking, etc., might occur in the first gas barrier layer due to any external factor such as bending, pulling after the film formation, etc. In this context, the thickness of the first gas barrier layer means an average value of distances from the bottom surface of the first gas barrier layer to the surface in which the concave-convex pattern 380 is formed.

When the first gas barrier layer is formed as the multilayer film, the water vapor transmission rate of the first gas barrier layer is preferably not more than 10⁻² g·m⁻²·day⁻¹ to allow the gas barrier member 300 to have an enough gas barrier property. In that case, the water vapor transmission rate of the first film 360 may exceed 10⁻² g·m⁻²·day⁻¹.

### <Adhesive layer>

The gas barrier member 300 includes the adhesive layer 330 between the base member 340 and the first film 360. When the first gas barrier layer is formed only of the first film 360, when the first gas barrier layer is formed only of a film formed by the dry process, or when a lowermost layer (a layer facing the base member 340) of the first gas barrier layer is a film formed by the dry process, the first film 360 and the base member 340 are joined via the adhesive layer 330. The thickness of the adhesive layer 330 is preferably in a range of 500 nm to 20 µm. When the first gas barrier layer is formed by the first film 360 and at least one film that is different from the first film 360 and disposed under the first film 360 (on the side facing the base member 340), and the lowermost layer (the layer facing the base member 340) of the first gas barrier layer is a film formed by the wet process, the first film 360 and the base member 340 may be joined via the film that is the lowermost layer of the first gas barrier layer and is formed by the wet process, thus making it possible to eliminate the adhesive layer 330. Namely, the adhesive layer 330 is not an indispensable element for the member manufactured by the manufacturing method according to the second embodiment of the present invention.

As the material for the adhesive layer 330, it is possible to use any of those listed as the materials that may be used for the adhesive layer 30 of the gas barrier member 100a.

### <Second film>

As depicted in Fig. 8(b), the gas barrier member 300a, which is obtained by the fourth modified embodiment of the method for manufacturing the gas barrier member with the concave-convex pattern which will be described later, includes the second film 370, as the second gas barrier layer, between the base member 340 and the adhesive layer 330. As the material for the second film 370, it is possible to use any of those listed as the inorganic materials or the organic materials (resin materials) that may be used for the first film 360. The second film 370 may be formed by the dry process or the wet process as described later.

When the gas barrier member 300a is used as an optical substrate of a light emitting element, the second film 370 preferably has a light transmission property. For example, the second film 370 preferably has a transmittance of not less than 80% at a measurement wavelength of 550 nm, more preferably has a transmittance of not less than 90% at the measurement wavelength of 550 nm.

The thickness of the second film 370 is preferably in a range of 5 nm to 20 µm. When the thickness is less than 5 nm, there are many cases of film defect, and any sufficient moisture-preventing effect (gas barrier effect) cannot be obtained. When the thickness exceeds 20 µm, although the moisture-preventing effect is theoretically high, the internal stress is high, which in turn makes the second film 370 to be brittle. This makes it impossible to obtain any desired moisture-preventing effect. Further, when the base member 340 is made from a flexible material, there is such a fear that any damage including cracking, etc., might occur in the second film 370 due to any external factor such as bending, pulling after the film formation, etc.

Although Fig. 8(b) depicts a structure in which the second gas barrier layer is formed by the second film 370 as a single layer, the second gas barrier layer may be formed by a multilayer film including the second film 370 and at least one film different from the second film 370. The at least one film different from the second film 370 may be made from any of those listed as the materials that may be used for the second film 370. A stress relaxation layer may be provided between respective layers.

When the gas barrier member, of which second gas barrier layer is formed as the multilayer film, is used as an optical substrate of a light-emitting element, the second gas barrier layer preferably has a light transmission property. The second gas barrier layer preferably has a transmittance of not less than 80% at a measurement wavelength of 550 nm, more preferably has a transmittance of not less than 90% at the measurement wavelength of 550 nm.

When the second gas barrier layer is formed as the multilayer film, the thickness of the second gas barrier layer is preferably in a range of 5 nm to 20 µm. When the thickness is less than 5 nm, there are many cases of film defect, and any sufficient moisture-preventing effect (gas barrier effect) cannot be obtained. When the thickness exceeds 20 µm, although the moisture-preventing effect is theoretically high, the internal stress is high, which in turn makes the second gas barrier layer to be brittle. This makes it impossible to obtain any desired moisture-preventing effect. Further, when the base member 340 is made from a flexible material, there is such a fear that any damage including cracking, etc., might occur in the second gas barrier layer due to any external factor such as bending, pulling after the film formation, etc.

When the second gas barrier layer is formed as the multilayer film, the water vapor transmission rate of the second gas barrier layer is preferably not more than 10⁻² g·m⁻²·day⁻¹ to allow the gas barrier member to have an enough gas barrier property. In that case, the water vapor transmission rate of the second film may exceed 10⁻²g·m⁻²·day⁻¹.

### [Second embodiment of method for manufacturing gas barrier member]

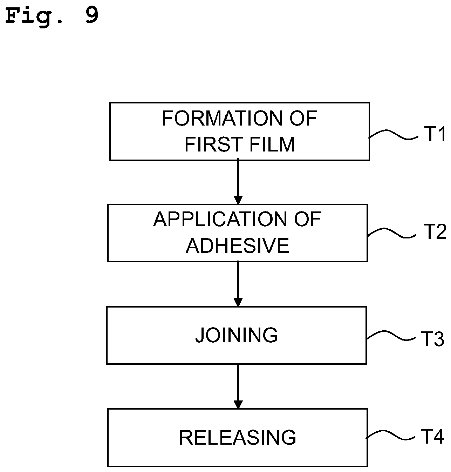

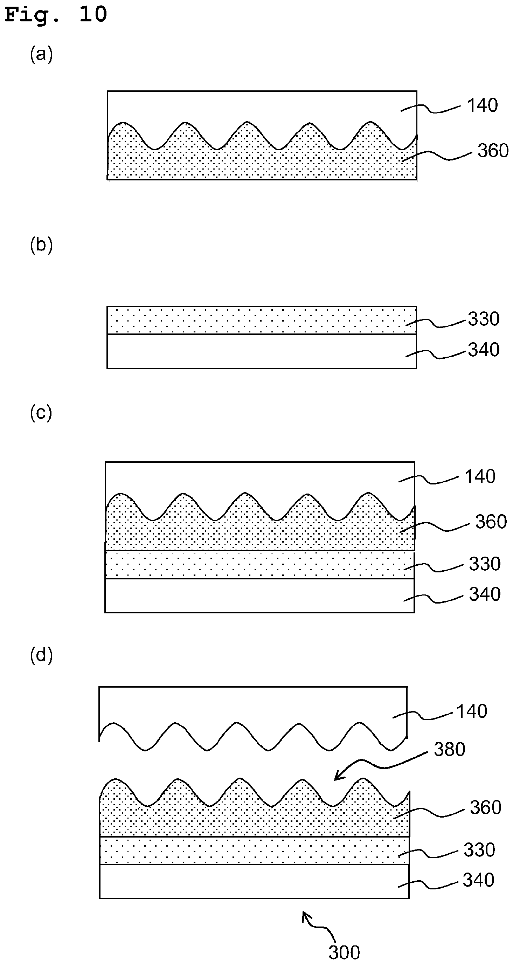

An explanation will be made about the second embodiment of the method for manufacturing the gas barrier member. As depicted in Fig. 9, the method for manufacturing the gas barrier member mainly includes: a step T1 of forming the first film on the concave-convex pattern of the mold by the dry process; a step T3 of joining the base member to the first film formed on the mold; and a step T4 of releasing the mold from the first film. Before the joining step T3, it is allowable to provide a step T2 of applying adhesive on the first film formed on the mold or a surface of the base member to be joined to the first film. In the following, the mold with the concave-convex pattern and the manufacturing method thereof will be explained first, and then the steps T1 to T4 will be sequentially explained with reference to Figs. 10(a) to 10(d).

### <Mold with concave-convex pattern>

As the mold used in the method for manufacturing the gas barrier member according to the second embodiment, it is possible to use a mold similar to that used in the method for manufacturing the gas barrier member according to the first embodiment.

### <First film formation step>

As depicted in Fig. 10(a), in the method for manufacturing the gas barrier member according to the second embodiment, the first film 360 is formed, as the first gas barrier layer, on a surface of the mold 140 in which the concave-convex pattern is formed (step T1 of Fig. 9). The first film 360 can be formed by depositing the inorganic material, such as metal oxide, metal nitride, metal oxynitride, metal sulfide, or metal carbide on the concave-convex pattern surface of the mold 140 by a well-known dry process, such as a physical vapor deposition method (PVD) including evaporation, sputtering, and the like; or a chemical vapor deposition method (CVD). The first film 360 formed by such a dry process has a low water vapor transmission rate and a high gas barrier property.

The first film 360 can be formed, for example, by the sputtering, electron beam heating evaporation method, atmospheric-pressure plasma CVD, or the like described in the first embodiment of the method for manufacturing the gas barrier member.

A surface modified layer may be provided on the first film 360 to improve the adhesion property between the first film 360 and the adhesive layer 330 which will be described later. The surface modified layer can be formed by any of those listed as the materials and the methods that may be used for the surface modified layer provided on the first film 60 in the first embodiment of the method for manufacturing the gas barrier member.

### <Adhesive applying step>

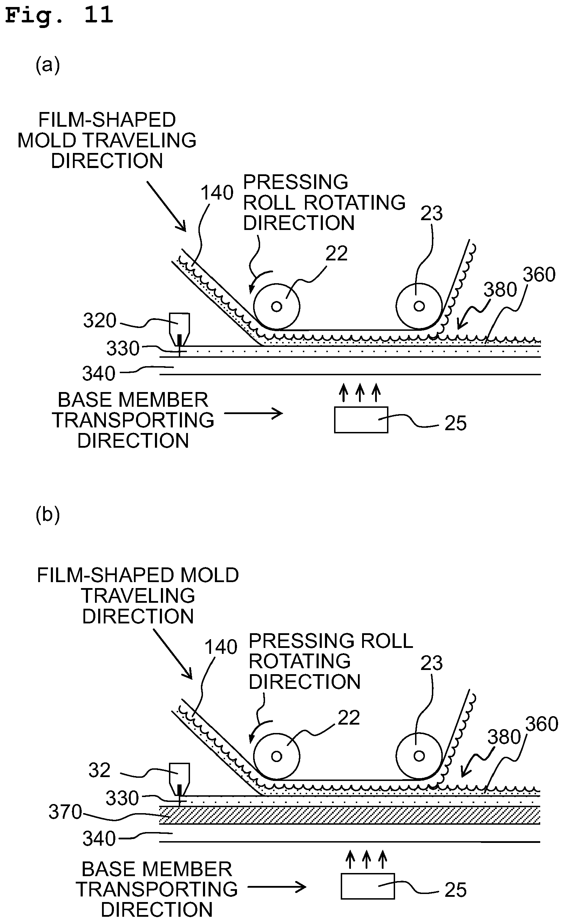

Subsequently, as depicted in Fig. 10(b), adhesive is applied on the base member 340 to form the adhesive layer 330 (step T2 of Fig. 9). For example, as depicted in Fig. 11(a), the adhesive layer 330 is formed on the base member 340 by feeding or sending the base member 340 to the vicinity of the tip of a die coater 320, and discharging adhesive from the die coater 320. From a viewpoint of mass-production, the adhesive is preferably applied on the base member 340 continuously by the die coater 320 provided at a predetermined position while the base member 340 is continuously transported. As the adhesive applying method, it is possible to use any of those listed as the methods for applying adhesive in the first modified embodiment of the method for manufacturing the gas bas barrier member.

When adhesive is applied on the base member 340, the adhesive applying step may be performed before the first film formation step. Before applying adhesive on the base member 340, a surface modified layer may be provided on the base member 340 to improve the adhesion property between the base member 340 and the adhesive layer 330. The surface modified layer can be formed, similarly to the case in which the surface modified layer is formed on the first film 360, in such a manner that the surface of the base member 340 is coated with a coupling agent or the surface of the base member 340 is subjected to treatment with an energy ray, such as plasma treatment, corona treatment, excimer irradiation treatment, or UV/O₃ treatment, etc. The adhesive layer 330 may be formed on the first film 360 instead of formed on the base member 340.

### <Joining step>

Subsequently, as depicted in Fig. 10(c), the first film 360 and the base member 340 are joined via the adhesive layer 330 by pressing the mold 140 with the first film 360 against the base member 340 with the adhesive layer 330 in a state where they are overlapped with each other (step T3 of Fig. 9). For example, as depicted in Fig. 11(a), the first film 360 can be brought into tight contact with the base member 340 in a state where they are overlapped with each other by sending the film-shaped mold 140 with the first film 360 between the pressing roll 22 and the base member 340 with the adhesive layer 330 that is being transported immediately below the pressing roll 22. Namely, when the first film 360 formed on the film-shaped mold 140 is pressed against the base member 340 by use of the pressing roll 22, the surface of the base member 340 and the adhesive layer 330 are covered (overlapped) with the first film 360 on the film-shaped mold 140 while the film-shaped mold 140 and the base member 340 are being synchronously transported. In this situation, by pressing the pressing roll 22 against the back surface (surface on the side opposite to the surface in which the concave-convex pattern is formed) of the film-shaped mold 140, the first film 360 on the film-shaped mold 140 moves with the adhesive layer 330 on the base member 340 while being brought into tight contact with the adhesive layer 330. In order to send the film-shaped mold 140 to the pressing roll 22, such a configuration is conveniently used wherein the film-shaped mold 140 is fed directly from the winding roll 14 (see Fig. 7) that is used to wind or roll up the film-shaped mold 140 thereon in the first film formation step. Then, the adhesive layer 330 is cured after the first film 360 and the adhesive layer 330 are brought into tight contact with each other as described above. As depicted in Fig. 11(a), the adhesive layer 330 can be cured by being irradiated with an energy ray, such as ultraviolet ray, by use of the UV lamp 25 or the like. Accordingly, the first film 360 is joined onto the base member 340 via the adhesive layer 330, and is fixed thereto.

Such a roll process using the pressing roll 22 has the following advantages. For example, it is possible to reduce joining pressure and releasing force (peeling force) owing to the line contact between the first film 360 on the film-shaped mold 140 and the adhesive layer 330 on the base member 340, thereby making it possible to easily manufacture a gas barrier member with a larger area; and it is possible to press the film-shaped mold 140 against the entire surface of the base member 340 uniformly, thereby bringing the first film 360 into tight contact with the base member 340 uniformly via the adhesive layer 330 and preventing any tight adhesion failure.

As the pressing roll 22, it is possible to use a roll similar to the pressing rolls 22a and 22b that are used in the first embodiment of the method for manufacturing the gas barrier member. Further, a supporting roll may be provided to face the pressing roll 22 and to sandwich the substrate 340 between the supporting roll and the pressing roll 22, or a supporting stand configured to support the substrate 340 may be provided, for the purpose of resisting the pressure applied by the pressing roll 22.

### <Releasing step>

As depicted in Fig. 10(d), the mold 140 is released from the first film 360 after the first film 360 is joined on the base member 340 (step T4 of Fig. 9). Any publicly known releasing method can be adopted as the mold releasing method. In a case of using the mold with the concave-convex pattern in which each of concavities and convexities has an elongated shape and a waveform structure in which inclination is gentle, there is an advantage that mold releasability is good. Since the first film 360 is firmly joined to the base member 340 via the cured the adhesive layer 330, there is no possibility that any portions of the first film 360 is released from the base member 340 in a state of partially adhering to the mold 140. In the roll process, releasing force may be smaller than that in the pressing system, and the mold 140 is easily released from the first film 360 without allowing the first film 360 to remain on the mold 140. Further, a releasing roll may be used to improve the mold releasability. As depicted in Fig. 11(a), a releasing roll (peeing roll) 23 may be disposed downstream of the pressing roll 22. The releasing roll 23 rotates and supports the film-shaped mold 140 and the first film 360 while urging them against the base member 340 and the adhesive layer 330, thus maintaining a state in which the first film 360 adheres to the adhesive layer 330 as long as a distance between the pressing roll 22 and the releasing roll 23 (for a certain period of time). Then, a path of the film-shaped mold 140 is changed so that the film-shaped mold 140 is pulled up above the releasing roll 23 on the downstream side of the releasing roll 23, thereby releasing (peeling off) the film-shaped mold 140 from the first film 360. The concave-convex pattern 380, which is transferred from the concave-convex pattern formed on the surface of the mold 140, is formed on the first film 360 from which the mold 140 is released.

As described above, it is possible to manufacture the gas barrier member 300, as depicted in Fig. 8(a), in which the first film 360 is formed on the base member 340 and the adhesive layer 330 is formed between the base member 340 and the first film 360.

Similar to the first embodiment of the method for manufacturing the gas barrier member, a covering layer may be formed on the surface of the first film 360 of the gas barrier member 300. A hydrophobization treatment may be performed on the surface of the first film 360 (the surface of the covering layer when the covering layer is formed). A protective layer or various functional layers may be formed on the surface of the first film 360 of the gas barrier member 300 (the surface of the covering layer when the covering layer is formed). Instead of the film-shaped mold, it is allowable to use a hard mold, such as a metal mold or a quartz mold.

In the method for manufacturing the gas barrier member according to the second embodiment, the first film formed on the concave-convex pattern surface of the mold is joined to the base member and the mold is released from the first film, which enables to obtain the first film that is formed by the dry process and has the concave-convex pattern transferred from the concave-convex pattern of the mold. In a case of forming the concave-convex pattern in the film formed by the dry process, photolithography is typically used. The manufacturing method of the second embodiment, however, can form the concave-convex pattern without photolithography that causes a large amount of waste liquid, and thus the manufacturing method of the second embodiment is environmentally friendly. Further, the manufacturing method of the second embodiment can continuously produce the member with the concave-convex pattern at high speed by using the roll process, and thus the manufacturing method of the second embodiment has high production efficiency. In a case of manufacturing the member with the concave-convex pattern by using the mold with the concave-convex pattern, any of the following methods is typically used: a method in which the base member is coated with a transfer material having relatively high fluidity through the wet process and the concave-convex pattern surface of the mold is pressed against the coating film; a method in which the concave-convex pattern of the mold is coated with a transfer material having relatively high fluidity, the transfer material is allowed to permeate into the concave-convex pattern, and then the transfer material is transferred to another member. In each of the above methods, the transfer process restricts functions of the film with the concave-convex pattern formed by each of the above methods, which makes it impossible, in some cases, to obtain a film with a desired function. Meanwhile, the manufacturing method of the second embodiment can manufacture a member with a desired function by depositing the inorganic material on the convex-concave pattern through the dry process and transferring it to another member.

The gas barrier member manufactured by the manufacturing method of the second embodiment includes, as the first gas barrier layer, the first film formed by the dry process. Thus, the gas barrier member manufactured by the manufacturing method of the second embodiment has a good gas barrier property. Thus, similar to the gas barrier member manufactured by the manufacturing method of the first embodiment, the gas barrier member manufactured by the manufacturing method of the second embodiment is suitably used for organic EL elements, liquid crystal displays, solar cells, packaging applications, and the like, and has the advantage of easy storage.

[Third modified embodiment of method for manufacturing gas barrier member]

At least one film different from the first film may be formed on the first film formed on the mold after the first film formation step of the manufacturing method according to the second embodiment is performed. The at least one film different from the first film may be formed by the dry process similar to the first film or the wet process such as coating. In the third modified embodiment, the first film and the at least one film that is different from the first film and disposed on the first film form the first gas barrier layer. Each film formed by the wet process may contain an ultraviolet absorbent material.

As a precursor of the inorganic material, alkoxide or the like, such as silicon or titanium, may be used (sol-gel method). Or, polysilazane may be used as a precursor of the inorganic material.

In the joining step (T3) of the third modified embodiment, the first film and the base member are joined via the at least one film different from the first film. In the present invention, the wording "joining the base member to the first film formed on the mold" includes not only the case in which the first film and the base member are joined directly or via the adhesive layer but also the case in which the first film and the base member are joined via the at least one film different from the first film.

### [Fourth modified embodiment of method for manufacturing gas barrier member]

A method for manufacturing the gas barrier member according to the fourth modified embodiment includes, in addition to the respective steps of the manufacturing method according to the second embodiment, a step of forming the second film, as the second gas barrier layer, on the base member. The second film formation step is performed before the adhesive applying step. In a case of forming the adhesive layer on the first film formed on the mold during the adhesive applying step, it is only required that the second film formation step be performed before the joining step, that is, the second film formation step may be performed after the adhesive applying step. The second film can be formed by the dry process or the wet process.

In a case of forming the second film, the adhesive applying step, the joining step, and the releasing step, those of which will be subsequently performed, can be performed similarly to the manufacturing method of the second embodiment. For example, as depicted in Fig. 11(b), adhesive is applied on the second film 370 formed on the base member 340 by the die coater 320 to form the adhesive layer 330 (adhesive applying step). Then, the first film 360 and the second film 370 are brought into tight contact with each other via the adhesive layer 330 by sending the film-shaped mold 140 with the first film 360 between the pressing roll 22 and the base member 340 that is formed with the second film 370 and the adhesive layer 330 and is being transported immediately below the pressing roll 22. Then, the first film 360 is joined and fixed onto the second film 370 by curing the adhesive layer 330 through irradiation with ultraviolet ray or the like (joining step). Then, the mold 140 is pulled up above the releasing roll 23, thereby releasing (peeling off) the mold 140 from the first film 360 (releasing step). Accordingly, it is possible to produce the gas barrier member 300a with the concave-convex pattern 380 in which the second film 370 and the first film 360 are formed on the base member 340 in that order and the adhesive layer 330 is formed between the first film 360 and the second film 370, as depicted in Fig. 8(b).

A surface modified layer may be provided on the second film 370 to improve the adhesion property between the second film 370 and the adhesive layer 330. The surface modified layer can be formed by any of those listed as the materials and the methods that may be used for the case in which the surface modified layer is provided on the first film 370.

At least one film different from the second film may be formed on the second film. The at least one film that is different from the second film and disposed on the second film may be formed by the dry process or the wet process. In that case, the second film and the at least one film that is different from the second film and disposed on the second film form the second gas barrier layer.

### [Light emitting element]

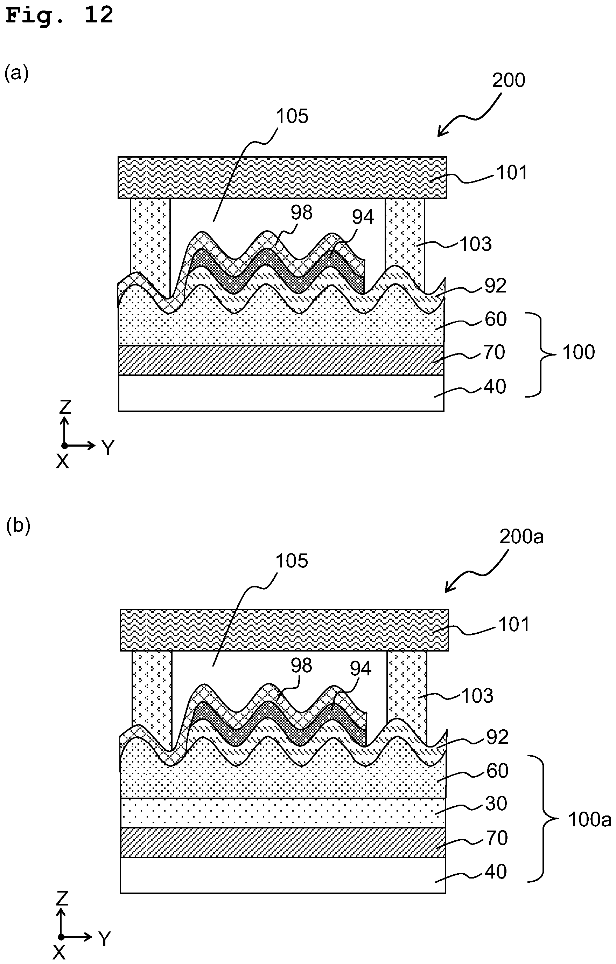

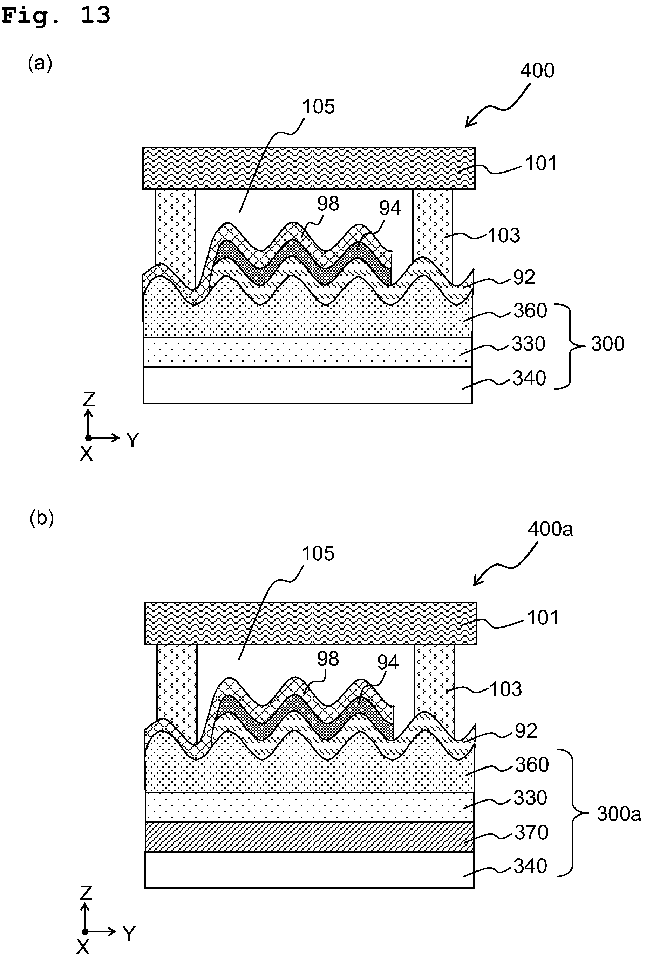

Next, an explanation will be made about an embodiment of a light emitting element manufactured by using the gas barrier member with the concave-convex pattern that is obtained by any of the manufacturing methods according to the embodiments and the modified embodiments. As depicted in Figs. 12(a), 12(b), 13(a), and 13(b), each of the light emitting elements 200, 200a, 400, and 400a includes a first electrode layer 92, an organic layer 94, and a second electrode layer 98 in that order on one of the gas barrier members 100, 100a, 300, and 300a. The gas barrier member 100 is formed by the base member 40, the second film 70, and the first film 60; the gas barrier member 100a is formed by the base member 40, the second film 70, the adhesive layer 30, and the first film 60; the gas barrier member 300 is formed by the base member 340, the adhesive layer 330, and the first film 360; and the gas barrier member 300a is formed by the base member 340, the second film 370, the adhesive layer 330, and the first film 360. Each of the light emitting elements 200, 200a, 400, and 400a may further include a sealing member 101 and a sealing adhesive layer 103.

### <First electrode>

The first electrode 92 may be a transparent electrode so that the light from the organic layer 94 formed on the first electrode 92 passes toward the base member 40. The first electrode 92 is preferably stacked such that the surface of the first electrode 92 maintains or shows the concave-convex pattern formed in the surface of the first film 60.

Those usable as the material for the first electrode 92 include, for example, indium oxide, zinc oxide, tin oxide, indium-tin oxide (ITO) that is a composite material thereof, gold, platinum, silver, and copper. Among these materials, ITO is preferable from the viewpoint of transparency and electrical conductivity. The thickness of the first electrode 92 is preferably within a range of 20 to 500 nm.

### <Organic layer>

The organic layer 94 is formed on the first electrode 92. The organic layer 94 is not particularly limited, provided that the organic layer 94 is usable as an organic layer of the organic EL element. As the organic layer 94, any publicly known organic layer can be used as appropriate.

As depicted in Figs. 12(a), 12(b), 13(a), and 13(b), the surface of the organic layer 94 (an interface between the organic layer 94 and the second electrode 98) may be formed to maintain the concave-convex pattern formed in the surface of each of the first films 60, 360. Or, the surface of the organic layer 94 may be flat without maintaining the concave-convex pattern formed in the surface of each of the first films 60, 360. When the surface of the organic layer 94 is formed to maintain the concave-convex pattern formed in the surface of each of the first films 60, 360, plasmon absorption due to the second electrode 98 is reduced to improve light extraction efficiency. Those usable as the material of the hole transporting layer include, for example, aromatic diamine compounds such as phthalocyanine derivatives, naphthalocyanine derivatives, porphyrin derivatives, N,N'-bis(3-methylphenyl)-(1,1'-biphenyl)-4,4'-diamine (TPD), and 4,4'-bis[N-(naphthyl)-N-phenyl-amino]biphenyl(α-NPD); oxazole; oxadiazole; triazole; imidazole; imidazolone; stilbene derivatives; pyrazoline derivatives; tetrahydroimidazole; polyarylalkane; butadiene; and 4,4',4"-tris(N-(3-methylphenyl)N-phenylamino)triphenylamine (m-MTDATA). The examples of materials of the hole transporting layer, however, are not limited to the above-described materials. The light emitting layer is provided in order that a hole injected from the first electrode 92 and an electron injected from the second electrode 98 are recombined to occur light emission. Those usable as the material of the light emitting layer include, for example, metallo-organic complex such as anthracene, naphthalene, pyrene, tetracene, coronene, perylene, phthaloperylene, naphthaloperylene, diphenylbutadiene, tetraphenylbutadiene, coumarin, oxadiazole, bisbenzoxazoline, bisstyryl, cyclopentadiene, and aluminum-quinolinol complex (Alq3); tri-(p-terphenyl-4-yl)amine; 1-aryl-2,5-di(2-thienyl) pyrrole derivatives; pyran; quinacridone; rubren; distyrylbenzene derivatives; distyryl arylene derivatives; distyryl amine derivatives; and various fluorescent pigments or dyes. Further, it is preferable that light-emitting materials selected from the above compounds be mixed as appropriate and then used. Furthermore, it is possible to preferably use a material system generating emission of light from a spin multiplet, such as a phosphorescence emitting material generating emission of phosphorescence and a compound including, in a part of the molecules, a constituent portion formed by the above materials. The phosphorescence emitting material preferably includes heavy metal such as iridium. A host material having high carrier mobility may be doped with each of the light-emitting materials as a guest material to generate the light emission using dipole-dipole interaction (Forster mechanism) or electron exchange interaction (Dexter mechanism). Those usable as the material of the electron transporting layer include, for example, heterocyclic tetracarboxylic anhydrides such as nitro-substituted fluorene derivatives, diphenylquinone derivatives, thiopyran dioxide derivatives, and naphthaleneperylene; and metallo-organic complex such as carbodiimide, fluorenylidene methane derivatives, anthraquino dimethane and anthrone derivatives, oxadiazole derivatives, and aluminum-quinolinol complex (Alq3). Further, in the oxadiazole derivatives mentioned above, it is also possible to use, as an electron transporting material, thiadiazole derivatives in which oxygen atoms of oxadiazole rings are substituted by sulfur atoms and quinoxaline derivatives having quinoxaline rings known as electron attractive group. Furthermore, it is also possible to use a polymeric material in which the above materials are introduced into a macromolecular chain or the above materials are made to be a main chain of the macromolecule. Note that the hole transporting layer or the electron transporting layer may also function as the light-emitting layer.

From the viewpoint of facilitating the electron injection from the second electrode 98, a layer made from a metal fluoride or metal oxide such as lithium fluoride (LiF) or Li₂O₃, a highly active alkaline earth metal such as Ca, Ba, or Cs, an organic insulating material, or the like may be provided as an electron injection layer between the organic layer 94 and the second electrode 98. Further, from the viewpoint of facilitating the hole injection from the first electrode 92, it is allowable to provide, as a hole injection layer between the organic layer 94 and the first electrode 92, a layer made from triazol derivatives, oxadiazole derivative, imidazole derivative, polyarylalkane derivatives, pyrazoline and pyrazolone derivatives, phenylenediamine derivative, arylamine derivatives, amino-substituted calcone derivatives, oxazole derivatives, styrylanthracene derivatives, fluorenone derivatives, hydrazone derivatives, stilbene derivatives, silazane derivatives, aniline-based copolymers, or electroconductive high-molecular oligomar, particularly thiophene oligomer.

Furthermore, when the organic layer 94 is a stacked body formed by the hole transporting layer, the light emitting layer, and the electron transporting layer, the thicknesses of the hole transporting layer, the light emitting layer, and the electron transporting layer are preferably within a range of 1 nm to 200 nm, a range of 5 nm to 100 nm, and a range of 5 nm to 200 nm, respectively.

### <Second electrode>

The second electrode 98 is formed on the organic layer 94. As the material of the second electrode 98, a substance having a small work function can be used as appropriate, although the material of the second electrode 98 is not particularly limited to this. For example, the second electrode 98 may be a metal electrode using aluminum, MgAg, MgIn, AlLi, or the like. The thickness of the second electrode 98 is preferably in a range of 50 to 500 nm. The second electrode 98 may be stacked such that the surface of the second electrode 98 maintains or shows the concave-convex pattern formed in the surface of the first film 60. A polarizing plate may be put on the second electrode 98 to address specular reflection of the second electrode 98 made from metal.

### <Sealing member>

The sealing member 101 is disposed to face each of the base members 40, 340 so as to define a space (sealed space) 105 intervening between the sealing member 101 and each of the base members 40, 340. The first electrode 92, the organic layer 94 and the second electrode 98 are disposed in the sealed space 105. The sealing member 101 can be fixed to each of the base members 40, 340 by using the sealing adhesive layer 103. The sealing adhesive layer 103 may be positioned between each of the bases members 40, 340 and the sealing member 101 in a Z direction (a normal direction of each of the base members 40, 340) indicated in Figs. 12(a), 12(b), 13(a), and 13(b), and may be positioned to surround the organic layer 94 in an XY direction (an in-plane direction of each of the base members 40, 340). Owing to the presence of the sealing member 101 and the sealing adhesive layer 103, it is possible to prevent moisture and/or oxygen from entering the sealed space 105. With this, any degradation of the organic layer 94, etc., is reduced, which in turn improves the service life of each of the light emitting element 200, 200a, 400, and 400a. Further, in order to effectively extract the light emitted from the organic layer 94, the sealing adhesive layer 103 is preferably formed to be separated from the organic layer 94 by a predetermined spacing distance (clearance), without contacting the organic layer 94. The predetermined spacing distance is preferably, for example, not less than 1 µm.

The material of the sealing member 101 may be any material having a high gas barrier property. Those usable as the material of the sealing member 101 include, for example, any publicly known gas barrier films used for packaging materials and the like, such as a plastic film in which silicon oxide or aluminum oxide is deposited; a laminate (stacked object) formed by a ceramic layer and an impact-attenuating polymer layer; metal foil laminated with a polymer film; a sealing can made from glass; a sealing can made from metal; and an engraved glass.

As the material of the sealing adhesive layer 103, it is possible to use, without any restriction, any adhesive widely used for glass, a plastic substrate, or the like. Further, it is possible to use any of those listed above as the materials that may be used for the adhesive layer 30.

The sealed space 105 may be filled with an inactive or inert gas or the like. N₂ can be used as the inactive gas, and instead of N₂, a noble gas such as He or Ar is preferably used. Further, a noble gas obtained by mixing He with Ar is also preferable. The ratio of the inactive gas in gases is preferably in a range of 90% by volume to 100% by volume. Alternatively, the sealed space 105 may be filled with infilling such as a solid or liquid resin, glass, an inactive oil such as a fluorine-based inactive oil, or a gel material. The infilling is preferably transparent or cloudy. Further, a water-absorbing substance may be disposed in the sealed space 105. The water-absorbing substance is exemplified, for example, by barium oxide. Specifically, for example, high-purity barium oxide powder produced by SIGMA-ALDRICH CO., LLC. can be disposed in the sealed space 105 by being put or stuck on the sealing member 101 by using a fluororesin-based semitransparent film with adhesive (MICROTEX S-NTF8031Q produced by NITTO DENKO CORPORATION) or the like. Alternatively, any commercially available water-absorbing substances produced, for example, by W.L. Gore & Associates and Futaba Corporation are preferably used.

Each of the light emitting elements 200, 200a, 400, and 400a may include an optical functional layer on a surface of the base member 40 or the base member 340 on the side opposite to the surface on which the first film 60 or the first film 360, etc. is/are formed (the surface serving as a light-extracting surface of the light emitting element). The optical functional layer is not particularly limited, provided that the optical functional layer is usable for light extraction of the light emitting element. Any optical member having a structure capable of extracting light to the outside of the element while controlling refraction of light, concentration of light, diffusion (scattering) of light, diffraction of light, reflection of light, and the like, can be used as the optical functional layer. As the optical functional layer, various lens members, a diffusion sheet or plate formed by a transparent body into which diffusion material is blended, a diffusion sheet or plate having a concave-convex structure (concave-convex pattern) on the surface thereof, a diffraction grating, a member having an antireflection function, or the like may be used. The various lens members include a convex lens such as the hemispherical lens, a concave lens, a Fresnel lens, a prism lens, a cylindrical lens, a lenticular lens, a micro lens including a concave-convex layer that can be formed by a method similar to the method for manufacturing the gas barrier member with the concave-convex structure layer as described above, and the like. Of the above examples, each of the lens members is preferably used because light can be extracted efficiently. Further, a plurality of lens members may be used as the optical functional layer. In that case, a so-called micro lens (array) may be formed by arranging or arraying fine or minute lens members. A commercially available product may be used for the optical functional layer. Such an optical functional layer prevents light passing through each of the base members 40, 340 from being totally reflected at an interface between each of the base members 40, 340 (including the optical functional layer) and air, thereby improving light extraction efficiency.

Each of the light emitting elements 200, 200a, 400, and 400a of the present embodiment uses one of the gas barrier members 100, 100a, 300, and 300a having a good gas barrier property. This prevents deterioration due to moisture and/or oxygen, thus allowing the light emitting element to have a long service life. Since each of the first films 60, 360 includes the concave-convex pattern working as a diffraction grating, each of the light emitting elements 200, 200a, 400, and 400a has a good light emitting property.

Although the present invention has been explained as above with the embodiments and modified embodiments, the member with the concave-convex structure manufactured by the manufacturing method of the present invention is not limited to those described in the above-described embodiments and modified embodiments, and may be appropriately modified or changed within a range of the technical ideas described in the following claims. For example, the member with the concave-convex structure manufactured by the manufacturing method of the present invention is not limited to gas barrier members used in optical elements. Namely, the manufacturing method of the present invention can manufacture various functional members, in which a first functional layer (first film) and a second functional layer (second film) having predetermined functions are formed on a base member, and various functional members in which a layer (first film) having a predetermined function is formed on a base member by the dry process. Examples of the functional layers include a light reflection layer, a light scattering layer, an insulating layer, an electrode pattern layer, a conductive layer, an antifogging layer, a heat-insulating layer, an antifouling layer, an optical waveguide layer, a dielectric layer, a non-reflection layer, a low-reflection layer, a polarization functional layer, a light diffraction layer, a hydrophilic layer, and a water-repellent layer.

### INDUSTRIAL APPLICABILITY

In the method for manufacturing the member with the concave-convex pattern according to the first aspect of the present invention, there is very little restriction on the materials and film-forming methods for the first film and the second film. Thus, the method according to the first aspect can manufacture a functional member having a good function. In the method for manufacturing the member with the concave-convex pattern according to the second aspect of the present invention, it is possible to easily manufacture a member with a film that is formed by the dry process and has a surface formed with the concave-convex pattern. In the manufacturing method according to each of the first and second aspects of the present invention, the member with the concave-convex pattern is formed by transfer of the concave-convex pattern of the mold, without photolithography that causes a large amount of waste liquid, thus resulting in environmental friendliness and high production efficiency. In particular, the gas barrier member can be manufactured by forming films having a high gas barrier property, as the first film and the second film, through the method for manufacturing the member with the concave-convex pattern according to the first aspect, or by forming a film having a high gas barrier property through the dry process in the method for manufacturing the member with the concave-convex pattern according to the second aspect. An organic EL element using such a gas barrier member has a sufficient light emitting efficiency and a long service life due to the suppression of the deterioration caused by moisture and/or gas including oxygen. The gas barrier member obtained by the manufacturing method of the present invention can be suitably used for, in addition to the organic EL element, the production of optical substrates of various devices, such as liquid crystal displays and solar cells; the production of optical elements, such as micro lens arrays, nanoprism arrays, and optical waveguides; the production of optical components, such as lenses; the production of LED; the production of solar cells; the production of antireflection films; the production of semiconductor chips; the production of patterned media; the production of data storage; the production of electronic paper; the production of LSI; packaging of goods; packaging members for preventing any deterioration of foods, industrial goods, medical products, and the like; the biology field, such as immunoassay chips and cell culture sheets; and the like. Further, the method for manufacturing the member with the concave-convex pattern according to the present invention can be used for the manufacture of members with various functions, besides the gas barrier member.

### Reference Sign List:

30: adhesive layer, 40: base member, 60: first film, 70: second film, 80: concave-convex pattern, 92: first electrode, 94: organic layer, 98: second electrode, 100, 100a, 300, 300a: gas barrier member, 101: sealing member, 103: sealing adhesive layer, 140: mold, 200, 200a, 400, 400a: light emitting element, 330: adhesive layer, 340: base member, 360: first film, 370: second film, 380: concave-convex pattern

## Claims

1. A method for manufacturing a member with a concave-convex pattern, comprising:
a step of forming a first film on a concave-convex pattern formed on a surface of a mold;
a step of forming a second film on a base member;
a step of joining the first film and the second film by overlapping the mold with the base member; and
a step of releasing the mold from the first film joined to the second film.

2. The method for manufacturing the member with the concave-convex pattern according to claim 1, further comprising a step of applying adhesive on the first film formed on the mold or the second film formed on the base member before the joining step.

3. The method for manufacturing the member with the concave-convex pattern according to claim 1 or 2, further comprising a step of forming, on the first film formed on the mold, a film different from the first film and/or a step of forming, on the second film formed on the base member, a film different from the second film, before the joining step.

4. A method for manufacturing a member with a concave-convex pattern, comprising:
a step of forming a first film, through a dry process, on a concave-convex pattern formed on a surface of a mold;
a step of joining a base member to the first film formed on the mold; and
a step of releasing the mold from the first film.

5. The method for manufacturing the member with the concave-convex pattern according to claim 4, further comprising a step of applying adhesive on a surface of the base member, which is to be joined to the first film formed on the mold, or on the first film formed on the mold before the joining step.

6. The method for manufacturing the member with the concave-convex pattern according to claim 4 or 5, further comprising a step of forming a film different from the first film, through the dry process and/or a wet process, on the first film formed on the concave-convex pattern of the mold.

7. The method for manufacturing the member with the concave-convex pattern according to any one of claims 4 to 6, wherein the first film is formed by depositing silicon oxide, silicon oxynitride, or silicon nitride through the dry process in the step of forming the first film.

8. The method for manufacturing the member with the concave-convex pattern according to any one of claims 4 to 7, further comprising a step of forming a second film on the base member before the joining step.

9. The method for manufacturing the member with the concave-convex pattern according to any one of claims 1 to 3 and 8, wherein the first film and/or the second film has/have a water vapor transmission rate of not more than 10⁻² g·m⁻²·day⁻¹.

10. The method for manufacturing the member with the concave-convex pattern according to claim 3, wherein a first gas barrier layer formed by the first film and the film which is formed on the first film and different from the first film and/or a second gas barrier layer formed by the second film and the film which is formed on the second film and different from the second film has/have a water vapor transmission rate of not more than 10⁻² g·m⁻²·day⁻¹.

11. The method for manufacturing the member with the concave-convex pattern according to any one of claims 1 to 10, wherein:
(i) each of a plurality of convexities and each of a plurality of concavities of the concave-convex pattern of the mold has an elongated shape which extends while winding in a plane view; and
(ii) the plurality of convexities have extending directions, bending directions and lengths which are non-uniform among the plurality of convexities, and the plurality of concavities have extending directions, bending directions and lengths which are non-uniform among the plurality of concavities.

12. The method for manufacturing the member with the concave-convex pattern according to any one of claims 1 to 11, wherein the concave-convex pattern of the mold is an irregular concave-convex pattern in which an average pitch of concavities and convexities is in a range of 100 to 1500 nm and an average value of depth distribution of the concavities and convexities is in a range of 20 to 200 nm.

13. The method for manufacturing the member with the concave-convex pattern according to any one of claims 1 to 12, wherein a Fourier-transformed image of a concavity and convexity analysis image of the mold shows a circular or annular pattern substantially centered at an origin at which an absolute value of wavenumber is 0 µm⁻¹, and the circular or annular pattern is present within a region where the absolute value of wavenumber is in a range of not more than 10 µm⁻¹.

14. A member with a concave-convex pattern manufactured by the method for manufacturing the member with the concave-convex pattern according to any one of claims 1 to 13.

15. The member with the concave-convex pattern according to claim 14, wherein the member with the concave-convex pattern includes a gas barrier layer, and the first film is included in the gas barrier layer.

16. The member with the concave-convex pattern according to claim 15, wherein the gas barrier layer has a water vapor transmission rate of not more than 10⁻² g·m⁻²·day⁻¹.

17. An organic light emitting diode formed by successively stacking, on a member with a concave-convex pattern manufactured by the method for manufacturing the member with the concave-convex pattern according to any one of claims 1 to 13, a first electrode, an organic layer, and a metal electrode.
